(19)

**Europäisches Patentamt**
**European Patent Office**
**Office européen des brevets**

(11) **EP 4 633 071 A1**

(12) **EUROPEAN PATENT APPLICATION**
published in accordance with Art. 153(4) EPC

(43) Date of publication:
**15.10.2025 Bulletin 2025/42**

(21) Application number: **23918210.8**

(22) Date of filing: **02.11.2023**

(51) International Patent Classification (IPC):
**H04L 1/00** (2006.01)

(52) Cooperative Patent Classification (CPC):
**H04L 1/00**

(86) International application number:
**PCT/CN2023/129362**

(87) International publication number:
**WO 2024/156210 (02.08.2024 Gazette 2024/31)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.01.2023 CN 202310127882**

(71) Applicant: **ZTE Corporation**
**Shenzhen, Guangdong 518057 (CN)**

(72) Inventor: **YUAN, Yan**
**Shenzhen, Guangdong 518057 (CN)**

(74) Representative: **Savi, Massimiliano et al**
**Notarbartolo & Gervasi S.p.A.**
**Viale Achille Papa, 30**
**20149 Milano (IT)**

(54) **CODE SIGNAL PROCESSING METHOD, COMMUNICATION DEVICE, ELECTRONIC DEVICE, AND MEDIUM**

(57) Provided in the present application are a 64B/66B code signal processing method, a communication device, an electronic device, and a computer-readable medium. The method comprises: at a transmitting end, acquiring a 64B/66B code signal, wherein the 64B/66B code signal is composed of 64B/66B code blocks, and the 64B/66B code blocks comprise at least one of the following: an S code block, a T code block, a C code block, a D code block or an E code block; writing check information into the first 64B/66B code block following the T code block; and transmitting the 64B/66B code signal. The method further comprises: at a receiving end, receiving the 64B/66B code signal, which is transmitted at the transmitting end; acquiring the check information according to the T code block; and according to the check information, detecting whether there is a check error, and depending on whether there is a check error, replacing some of the 64B/66B code blocks, so as to finally obtain the 64B/66B code signal. In this way, an error introduced during the transmission process is marked.

Transmit end

Acquire a 64B/66B coded signal, where the 64B/66B coded signal is composed of 64B/66B code blocks — S1

Find the T code block and generate check information according to a preset scheme — S2

Write the check information into a 1st 64B/66B code block after the T code block — S3

Send the 64B/66B coded signal — S4

Receive end

Receive the 64B/66B coded signal sent by the transmit end — S7

Find the T code block and acquire the check information according to the T code block — S8

Detect according to the check information whether a check error exists, and replace a subset of the 64B/66B code blocks depending on whether a check error exists — S9

FIG. 3

**Description**

**CROSS-REFERENCE TO RELATED APPLICATION**

This application is filed on the basis of Chinese patent application No. 202310127882.7 filed January 29, 2023, and claims priority to the Chinese patent application, the entire contents of which are incorporated herein by reference.

**TECHNICAL FIELD**

The present disclosure relates to the field of communication technologies, and more particularly, to a 64B/66B coded signal processing method, a communication device, an electronic device, and a computer-readable medium.

**BACKGROUND**

Although an Ethernet Media Access Control (MAC) frame contains Frame Check Sequence-32 bits (FCS-32) check information, there is still a possibility that an erroneous MAC frame having a bit error passes the FCS-32 check and is identified as a correct MAC frame. Mean Time To False Packet Acceptance (MTTFPA) indicates how long it may take for an erroneous MAC frame to be accepted under a certain bit error rate condition. Ethernet standards require that MTTFPA must be longer than the age of the universe (14 billion years) under a certain bit error rate. After a MAC frame is 64B/66B coded, a 2-bit synchronization header of 64B/66B and a 64B/66B to RS layer processing procedure defined by IEEE 802.3 can ensure that the MTTFPA is greater than the age of the universe when the bit error rate is 10E-12. If 64B/66B is converted to 256B/257B coding with lower redundancy ratio, the bit error rate will be amplified. If no special processing is performed, the MTTFPA will not meet the requirement. At present, in the prior art, to reduce the impact of amplification of the bit error rate after 64B/66B is converted to 256B/257B coding with lower redundancy ratio, additional processing is generally required to ensure that the MTTFPA performance meets the requirement. The following three processing methods are commonly used.

Method 1: 256B/257B code blocks are used as a payload of an FEC block. When an uncorrectable error is detected in the FEC block, all the 256B/257B code blocks in this FEC block are converted to special 64B/66B code blocks containing error information.

Method 2: An additional check block is periodically added to 256B/257B code blocks. When an error is detected through the check block, all 256B/257B code blocks in the check range are converted to special 64B/66B code blocks containing error information.

Method 3: Additional check processing is performed on the 1st to 5th bits in 256B/257B code blocks. The 1st bit is placed in an overload of a service signal and is subjected to additional check processing, and the last 256 bits are placed in a payload of the service signal. After the 2nd to 5th bits in the 256B/257B code blocks are decoded, a Hamming distance of 2 bits is maintained, thereby providing additional check means.

Among the above three methods, Method 1 requires a specific condition, i.e., cannot be implemented if there is no FEC block. In addition, Method 1 cannot accurately locate an error in the MAC frame, i.e., if an FEC block includes a plurality of MAC frames and an uncorrectable error is detected in the FEC block, the MAC frame(s) where the error occurs cannot be located, and all the MAC frames included in the FEC block must be discarded. In other words, the MAC frame(s) where the error occurs cannot be identified and thus discarded, and some MAC frames that actually have no error are discarded erroneously. Method 2 requires an additional check block. However, the bandwidth of a 256B/257B coded signal is generally limited, and a check block can be added at intervals of a long time. When an error is detected through the check block, all 256B/257B code blocks in the check range need to be converted to special 64B/66B code blocks containing error information. As a result, data in the entire check range needs to be cached, resulting in a large processing delay. Similar to Method 1, Method 2 also cannot locate the MAC frame(s) where the error occurs. Method 3 does not require an additional check block, but requires the overhead of the service signal to provide sufficient bandwidth for placing information of the 1st bit in the 256B/257B code block, and needs to check the information of the 1st bit. Since the error detection capability provided by Hamming decoding is limited, the ability of Method 3 to improve the MTTFPA performance is limited. To sum up, after 64B/66B code blocks are converted to 256B/257B code blocks with lower redundancy ratio, all the existing three methods for improving the MTTFPA performance have defects. Therefore, it is necessary to provide a novel method for improving the MTTFPA performance of 64B/66B coded signals. This method can better improve MTTFPA performance without requiring the use of an FEC code block, without additionally occupying bandwidth of 64B/66B code blocks or 256B/257B code blocks, without occupying the bandwidth of the overhead of the service signal, and without introducing a large processing delay. This method can also be directly applied to 64B/66B code blocks, to make the MTTFPA performance meet the requirement even at a higher bit error rate.

## SUMMARY

Embodiment of the present disclosure provide a 64B/66B coded signal processing method, a communication device, an electronic device, and a computer-readable medium. An objective of the embodiments of the present disclosure is to improve the MTTFPA performance of 64B/66B coded signals in a simpler and more effective manner.

In accordance with one aspect of the present disclosure, an embodiment provides a 64B/66B coded signal processing method, including:

at a transmit end, acquiring a 64B/66B coded signal, where the 64B/66B coded signal is composed of 64B/66B code blocks, and the 64B/66B code blocks include at least one of an S code block, a T code block, a C code block, a D code block, or an E code block;

finding the T code block and generating check information according to a preset scheme;

writing the check information into a 1st 64B/66B code block after the T code block; and

sending the 64B/66B coded signal; and

at a receive end, receiving the 64B/66B coded signal sent by the transmit end;

finding the T code block and acquiring the check information according to the T code block;

detecting according to the check information whether a check error exists, and replacing a subset of the 64B/66B code blocks depending on whether a check error exists; and

finally obtaining the 64B/66B coded signal, so that an error introduced in the sending process is labeled.

In accordance with another aspect of the present disclosure, an embodiment provides a communication device, including a sending module and a receiving module, where the sending module is used at a transmit end to execute the 64B/66B coded signal processing method described above; and the receiving module is used at a receive end to execute the 64B/66B coded signal processing method described above.

In accordance with another aspect of the present disclosure, an embodiment provides an electronic device, including: one or more processors; and a memory, storing one or more programs which, when executed by the one or more processors, cause the one or more processors to implement the 64B/66B coded signal processing method described above.

In accordance with another aspect of the present disclosure, an embodiment provides a computer-readable medium, storing a computer program which, when executed by a processor, causes the processor to implement the 64B/66B coded signal processing method described above.

By the present disclosure, an error detected on 64B/66B code blocks is labeled, and when the 64B/66B coded signal is converted into a MAC frame, an end-of-frame flag of the corresponding MAC frame cannot be found due to the labeled error, and therefore the MAC frame is discarded. After the 64B/66B coded signal is converted into a MAC frame, there is a very high probability that an error that cannot be detected on 64B/66B code blocks will be detected by the FCS-32 check information of the MAC frame. As such, the probability that any error can be finally detected is sufficiently high, so that the MTTFPA indicator of the 64B/66B coded signal is improved. Compared with conventional methods, the present disclosure is applicable to all 64B/66B code blocks and can better improve the MTTFPA indicator without requiring the use of an FEC block, without additionally occupying bandwidth of the 64B/66B coded signal or 256B/257B coded signal, without buffering too much data which leads to a large delay, and without occupying the bandwidth of the overhead of the service signal.

## BRIEF DESCRIPTION OF DRAWINGS

FIG. 1 is a definition of 66 bits in a 64B/66B code block defined in IEEE 802.3 standards;

FIG. 2 is a frame structure of a MAC frame defined in IEEE 802.3 standards;

FIG. 3 is a schematic flowchart of a 64B/66B coded signal processing method according to an embodiment of the present disclosure;

FIG. 4 is a schematic diagram of a temporal relationship between 64B/66B code blocks during sending of a 64B/66B coded signal;

FIG. 5 is a schematic diagram of a check data area corresponding to check information generated during sending of a 64B/66B coded signal;

FIG. 6 is a schematic diagram of a temporal relationship between 64B/66B code blocks during receiving of a 64B/66B coded signal; and

FIG. 7 is a schematic diagram of a check data area corresponding to second check information generated during receiving of a 64B/66B coded signal.

## DETAILED DESCRIPTION

In order for those having ordinary skills in the art to better understand the technical schemes of the present disclosure, a 64B/66B coded signal processing method, a communication device, an electronic device, and a computer-readable medium provided in the embodiments of the present disclosure will be described in detail below in conjunction with the accompanying drawings.

Example embodiments are described more fully below with reference to the accompanying drawings, but the example embodiments may be embodied in different forms and the present disclosure is not to be construed as being limited to the embodiments set forth herein. Rather, these embodiments are provided so that the present disclosure will be thorough and complete, and will fully convey the scope of the present disclosure to those having ordinary skills the art.

The embodiments of the present disclosure and the features in the embodiments may be combined with each other if not in conflict.

As used herein, the term "and/or" includes any and all combinations of one or more of associated items listed.

The terminology used herein is used to describe particular embodiments only and is not intended to limit the present disclosure. As used herein, the singular forms "a," "an," and "the" are intended to include the plural forms as well, unless the context clearly dictates otherwise. It will also be understood that when used in this specification, the terms "include," "comprise," and/or "made of" as well as their variants mean that the stated features, integers, steps, operations, elements, and/or components are present, but do not exclude the presence or addition of one or more other features, integers, steps, operations, elements, components, and/or groups thereof.

Unless otherwise defined, the meanings of all the terms (including technical and scientific terms) used herein are intended to be the same as those commonly understood by those having ordinary skills in the art. It will also be understood that the terms such as those defined in common dictionaries should be construed as having meanings consistent with their meanings in the context of the related art and the present disclosure, and should not be construed as having idealized or over-formal meanings, unless otherwise expressly defined herein.

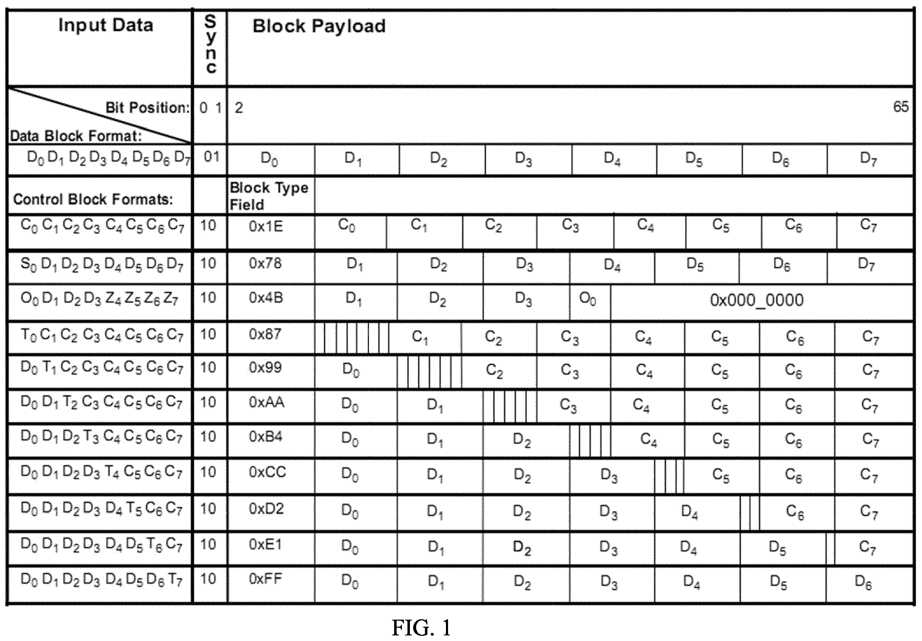

The present disclosure is based on 64B/66B coding defined in IEEE 802.3 clause 82. A definition of a 64B/66B code block is shown in FIG. 1. The 64B/66B code block includes 8 characters, including two types of characters: data characters or control characters. The length of the digital character is 8 bits. The length of the control character is 7 bits. The 64B/66B code block is used for transmitting a MAC frame. Start-of-frame control information and end-of-frame control information are needed to identify the start and end of the MAC frame, between which is data information of the MAC frame. As such, the MAC frame includes two different types of information: control information and data information. In addition, there are some other control information in the 64B/66B code block, e.g., idle control information used to indicate Idle and ordered set control information used to indicate ordered sets. When there is currently no MAC frame or other control information to be sent, the idle control information is sent. There are a variety of types of ordered set control information. For example, sequence ordered sets control information is a type of ordered set control information, indicating that it is currently in a local fault or remote fault state.

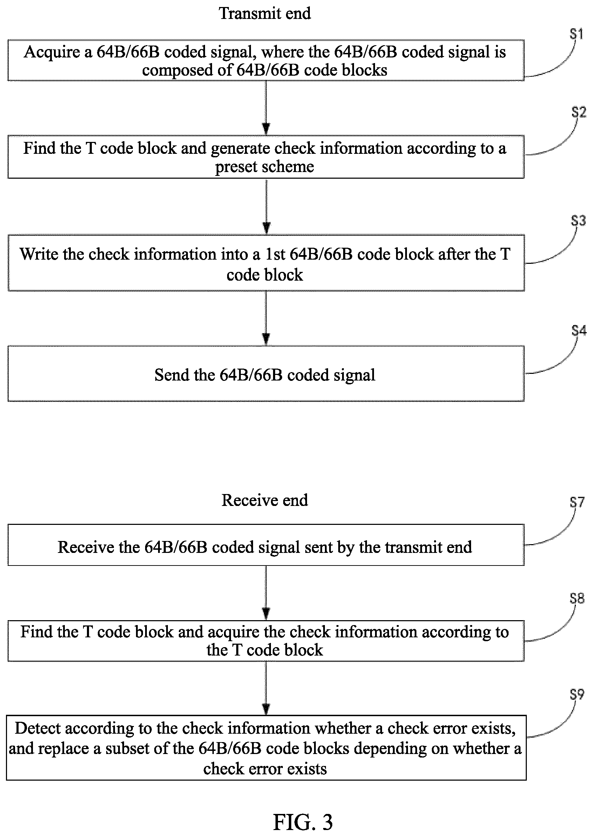

The control characters include a start-of-frame control character (S in FIG. 1) and an end-of-frame control character (T in FIG. 1) of the MAC frame, an idle control character for realizing rate padding (where C in FIG. 1 represents one control character, and the idle control character corresponds to a control character with a 7-bit value of 0), an error control character representing error information (where the error control character corresponds to a control character with a 7-bit value of 0x1e), and an LPI control character representing a low power idle state (where the LPI control character corresponds to a control character with a 7-bit value of 0x6, LPI corresponds to Low Power Idle, indicating a low-power idle state, which requires the support of hardware devices and is used to reduce power consumption of the device when there is no need to send MAC frames). In addition, the control information also includes an ordered set control block used to represent ordered set control information (implemented using a 64B/66B code block beginning with O in FIG. 1, where one ordered set control block includes a 4-bit ordered set control block type corresponding to $O_0$ in FIG. 1, 3 data characters used to represent information included in the ordered set control block, and 28 bits fixed to 0).

The 64B/66B code block is a bit block with a length of 66 bits. The first two bits in the 66-bit block form a synchronization header (or named synchronization bits), which is denoted by Sync in FIG. 1. If the synchronization header is 01, the 66-bit block is named 64B/66B data code block, and the 3rd to 66th bits in the 66-bit block are named information field. The information field includes 64 bits. In this case, the information field corresponds to 8 bytes of data characters. If the synchronization header is 10, the 66-bit block is named 64B/66B control code block. In this case, the 64 bits following the synchronization header must include control information, which may include at least one control character, or include one ordered set control block.

When the synchronization header is 10, the 3rd to 10th bits in the 66-bit block are named type field (block type field), the 11th to 66th bits are named information field. Only 11 types of values are defined for the type field. For details, see the values of block type field in FIG. 1. In the present disclosure, a 64B/66B code block is named one of five types of code blocks, namely, an S code block, a T code block, a C code block, a D code block, and an E code block, depending on whether this code block includes control information and according to the type of control information included. A 64B/66B code block having a synchronization header of 01 is named D code block. A 64B/66B code block having a synchronization header of 10, a 1st control character being a start-of-frame control character, and a type field of 0x78 is named S code block. The T code block has a synchronization header of 10, includes one end-of-frame control character, and has a type field of 0x87, 0x99, 0xaa, 0xb4, 0xcc, 0xd2, 0xe1, or 0xff. The C code block (C = Control) includes a C-I (I = Idle) code block and a C-O (O = Ordered sets) code block. The C-I code block has a synchronization header of 10, a type field of 0x1e, and an information field including 8 idle control characters, where the idle control character is 7 bits of 0. The C-O code block has a synchronization header of 10 and a type field of 0x4b, where first 28 bits of an information field of the C-O code block include a content and a type of ordered set control information, the ordered set control information occupies 24 bits, the type of the ordered set control information occupies 4 bits, and last 28 bits of the information field are fixed to 0x000_0000. All 64B/66B code blocks that do not meet the above conditions are named E code blocks. For example, a 64B/66B code block having a synchronization header of 10, a type field of 0x1e, and an information field including LPI information (with a 7-bit value of 0x6) or error information (with a 7-bit value of 0x1e) do not meet the above definitions of the D code block, the T code block, the S code block, and the C code block, and therefore is determined as an E code block.

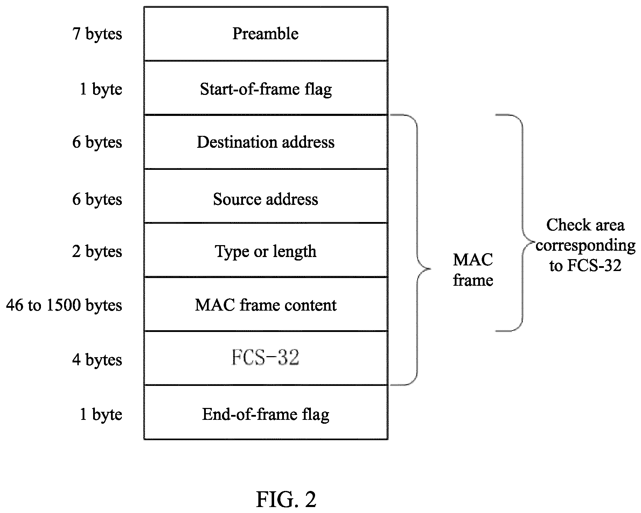

The core idea of the present disclosure is to implement two different check modes for each MAC frame. One of the check modes is FCS-32 check of the MAC frame itself. According to IEEE 802.3 standards, the last 4 bytes of data of the MAC frame are FCS-32 check information, the content of which is Cyclic Redundancy Check-32 bit (CRC-32) information. The check range is all data bytes of the MAC frame, and neither includes a start-of-frame control character and the following 7-byte preamble, nor includes the last 4-byte FCS-32 check information, as shown in FIG. 2. In FIG. 2, the 7-byte preamble and the 1-byte start-of-frame flag correspond to the S code block of the 64B/66B code block. The above 8 bytes do not belong to the MAC frame. A starting position of the MAC frame corresponds to a 6-byte destination address. The check range corresponding to the FCS-32 check information starts from the 6-byte destination address and ends at a byte preceding the FCS-32 check information. On the basis of this check, the present disclosure additionally provides a novel check method for the MAC frame. Check information generated by the novel check method may be 24 bits or 32 bits. A check algorithm used in the novel check method may be BIP-24, CRC-24, BIP-32, CRC-32, etc. A check range of the novel check method is a 64B/66B code block corresponding to the MAC frame. In this way, the checked content not only includes all the contents of the MAC frame, but also includes the synchronization header of the 64B/66B code block, i.e., the 64B/66B code block corresponding to the MAC frame is checked. According to the present disclosure, if an error occurs in the 64B/66B code block and this error cannot be detected by the FCS-32 check information based on the MAC frame, the possibility that the novel check mode does not report this error will be infinitely low. Similarly, if an error occurs in the 64B/66B code block and this error cannot be detected by the novel check mode, the possibility that the FCS-32 check information based on the MAC frame cannot detect this error will be infinitely low. As such, as long as the novel check mode detects an error, the corresponding MAC frame will be discarded. For the conventional FCS-32 check, when an error is detected by the FCS-32 check information based on the MAC frame, the current frame is discarded. The combination of the novel check mode and the conventional FCS-32 check mode can greatly reduce the probability of identifying an erroneous frame as a correct frame. Based on the idea of the present disclosure, bits to be used by the novel check mode need to be provided without additionally increasing the bandwidth of the 64B/66B code block, to ensure that the novel check mode does not increase the rate of the 64B/66B coded signal; and it is also necessary to consider how the current MAC frame to be discarded when an error is detected by the novel check mode, while minimizing the processing delay. Therefore, the present disclosure provides a plurality of embodiments, which will be described in detail below.

FIG. 3 is a schematic flowchart of a 64B/66B coded signal processing method according to an embodiment of the present disclosure. The 64B/66B coded signal processing method according to this embodiment includes executing the following steps S1 to S4 at a transmit end and executing the following steps S7 to S9 at a receive end, which will be sequentially described below.

Steps S1 to S4 are executed at the transmit end.

It can be understood that the transmit end receives a 64B/66B coded signal, adds check information to the received 64B/66B coded signal, and sends the 64B/66B coded signal to which the check information has been added.

At S1, a 64B/66B coded signal is acquired, where the 64B/66B coded signal is composed of 64B/66B code blocks.

The 64B/66B code blocks include at least one of an S code block, a T code block, a C code block, a D code block, or an E code block.

It can be understood that the 64B/66B code blocks each include a 2-bit synchronization header and a 64-bit block payload, the block payload includes an 8-bit type field and a 56-bit information field when the 2-bit synchronization header is 10, and the block payload includes a 64-bit information field when the 2-bit synchronization header is 01;

a synchronization header of the S code block is 10, a type field of the S code block includes a start-of-frame flag, and the start-of-frame flag is 0x78;

a synchronization header of the T code block is 10, a type field of the T code block includes an end-of-frame flag, and the end-of-frame flag is one of 0x87, 0x99, 0xaa, 0xb4, 0xcc, 0xd2, Oxel or 0xff;

the C code block includes a C-I code block and a C-O code block, where a synchronization header of the C-I code block is 10, a type field of the C-I code block is Oxle, an information field of the C-I code block includes 8 idle control characters, and the idle control character is 7 bits of 0; a synchronization header of the C-O code block is 10, a type field of the C-O code block is 0x4b, first 28 bits of an information field of the C-O code block include a content and a type of ordered set control information, and last 28 bits of the information field are fixed to 0x000_0000;

a synchronization header of the D code block is 01; and

the E code block is the 64B/66B code block other than the S code block, the T code block, the C code block, and the D code block.

For specific formats of various types of 64B/66B code blocks described above, see FIG. 1 and the related description of FIG. 1 above, which will not be repeated here.

It can be understood that the 64B/66B coded signal in the embodiments of the present disclosure is composed of any combination of S code blocks, T code blocks, C code blocks, D code blocks, or E code blocks, and the types of 64B/66B code blocks included in the 64B/66B coded signal and the number of 64B/66B code blocks of each type are not particularly limited in the embodiments of the present disclosure.

At S2, the T code block is found and check information is generated according to a preset scheme.

It can be understood that finding the T code block includes finding every T code block in the 64B/66B coded signal.

It can be understood that there are a variety of implementation methods of the preset scheme for generating the check information, and the specific implementation method of the preset scheme for generating the check information is not particularly limited herein, as long as the check range corresponding to the generated check information can cover the MAC frame.

At S3, the check information is written into a 1st 64B/66B code block after the T code block.

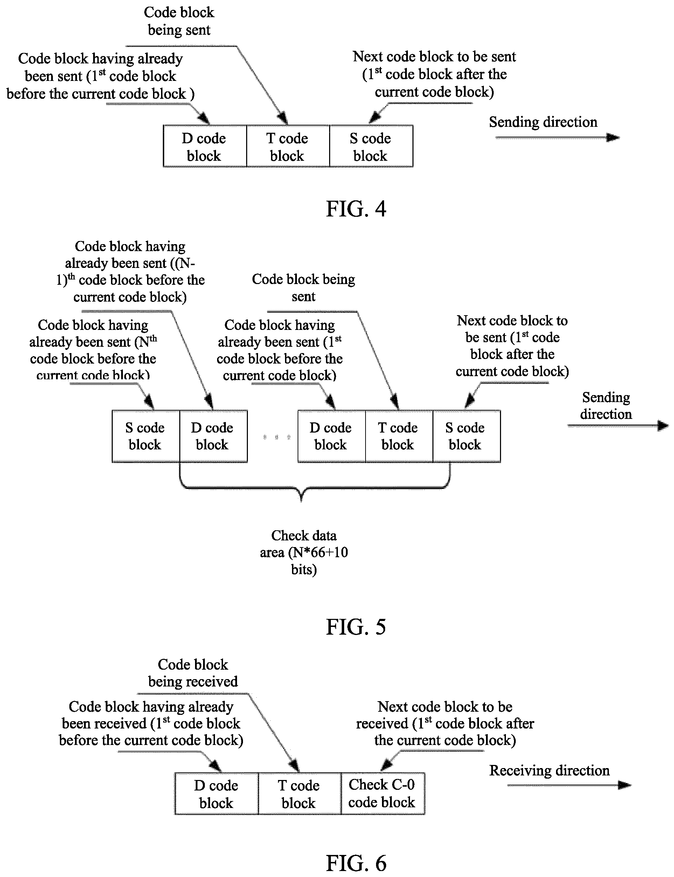

It can be understood that for the 1st 64B/66B code block after the T code block at the transmit end, the term "after" is relative to a sending direction. Assuming that a T code block is currently being sent, according to a sending order, a 64B/66B code block having already been sent corresponds to "before", and a 64B/66B code block to be sent corresponds to "after", i.e., a previous 64B/66B code block having been sent corresponds to the 1st code block before the T code block, and a next 64B/66B code block to be sent corresponds to the 1st code block after the T code block. As shown in FIG. 4, a T code block is currently being sent, a previous 64B/66B code block having been sent is a D code block, and a next 64B/66B code block to be sent is an S code block. In this case, the 1st code block before the T code block is the D code block, and the 1st code block after the T code block is the S code block.

It can be understood that before the check information is written into the 1st 64B/66B code block after the T code block, a preset 64B/66B code block needs to be added after the T code block, or the 1st 64B/66B code block after the T code block needs to be replaced with a preset 64B/66B code block, or the 1st 64B/66B code block after the T code block needs to be kept unchanged. After the above processing, the code block type of the 1st 64B/66B code block after the T code block is an expected type. The above processing may be implemented by a variety of methods.

It can be understood that the type of the preset 64B/66B code block is not particularly limited in the present disclosure, as long as the preset 64B/66B code block has sufficient bits to store the check information or other information.

At S4, the 64B/66B coded signal is sent.

It can be understood that the 64B/66B coded signal may be sent over a physical medium; or the 64B/66B coded signal is encapsulated into a service signal and the service signal is sent; or the 64B/66B coded signal is converted into a coded signal of another format, and the coded signal of the another format is sent. The specific implementation method of sending the 64B/66B coded signal is not limited herein, as long as the 64B/66B coded signal to which the check information has been added can be transferred from one location to another location.

Steps S7 to S9 are executed at the receive end.

It can be understood that the receive end receives the 64B/66B coded signal to which the check information has been added, checks the received 64B/66B coded signal to which the check information has been added, replaces a subset of the 64B/66B code blocks with a 64B/66B code block representing error information according to the check result, and finally obtains the 64B/66B coded signal, so that an error introduced in the sending process is labeled.

At S7, the 64B/66B coded signal sent by the transmit end is received.

It can be understood that the 64B/66B coded signal sent by the transmit end may be received through a physical medium; or

the service signal sent by the transmit end is received, and the 64B/66B coded signal is extracted from the service signal; or the coded signal of the another format sent by the transmit end is received, and the coded signal of the another format is converted into the 64B/66B coded signal.

At S8, the T code block is found and the check information is acquired according to the T code block.

It can be understood that finding the T code blocks includes finding every T code block in the 64B/66B coded signal received in step S7.

It can be understood that the method of acquiring the check information according to the T code block is related to the specific implementation of step S3, and the check information is acquired only from the 1st 64B/66B code block after the T code block.

At S9, it is detected according to the check information whether a check error exists, and a subset of the 64B/66B code blocks is replaced depending on whether a check error exists.

It can be understood that detecting according to the check information whether a check error exists may include a variety of implementation methods, and the specific implementation method of detecting according to the check information whether a check error exists is related to the specific implementation method of step S2. Replacing a subset of the 64B/66B code blocks depending on whether a check error exists may include a variety of specific implementation methods, and the specific implementation method of replacing a subset of the 64B/66B code blocks depending on whether a check error exists is related to the specific implementation method of step S3.

In the embodiments of the present disclosure, the error introduced in the sending process of the 64B/66B coded signal is labeled, so that in the process of finally converting the 64B/66B coded signal into a MAC frame, the ability to find the error in the MAC frame is greatly enhanced. In the process of sending the 64B/66B coded signal, even if more bit errors are introduced due to a poor sending environment and these bit errors cause more errors in the MAC frame, the probability that an erroneous MAC frame is identified as a correct MAC frame can be reduced, thereby improving the MTTFPA performance of the 64B/66B coded signal. Compared with conventional methods, the present disclosure is applicable to all 64B/66B code blocks and can better improve the MTTFPA indicator without requiring the use of an FEC block, without additionally occupying bandwidth of the 64B/66B coded signal or 256B/257B coded signal, without buffering too much data which leads to a large delay, and without occupying the bandwidth of the overhead of the service signal.

Another embodiment of the present disclosure provides a 64B/66B coded signal processing method. In the embodiment of the present disclosure, this method includes executing the following steps S101 to S104 at a transmit end and executing the following steps S107 to S109 at a receive end, which will be sequentially described below.

Steps S101 to S104 are executed at the transmit end.

At S101, a 64B/66B coded signal is acquired, where the 64B/66B coded signal is composed of 64B/66B code blocks.

The 64B/66B code blocks include at least one of an S code block, a T code block, a C code block, a D code block, or an E code block.

It can be understood that the 64B/66B code blocks each include a 2-bit synchronization header and a 64-bit block payload, the block payload includes an 8-bit type field and a 56-bit information field when the 2-bit synchronization header is 10, and the block payload includes a 64-bit information field when the 2-bit synchronization header is 01;

a synchronization header of the S code block is 10, a type field of the S code block includes a start-of-frame flag, and the start-of-frame flag is 0x78;

a synchronization header of the T code block is 10, a type field of the T code block includes an end-of-frame flag, and the end-of-frame flag is one of 0x87, 0x99, 0xaa, 0xb4, 0xcc, 0xd2, 0xe1 or 0xff;

the C code block includes a C-I code block and a C-O code block, where a synchronization header of the C-I code block is 10, a type field of the C-I code block is 0x1e, an information field of the C-I code block includes 8 idle control characters, and the idle control character is 7 bits of 0; a synchronization header of the C-O code block is 10, a type field of the C-O code block is 0x4b, first 28 bits of an information field of the C-O code block include a content and a type of ordered set control information, and last 28 bits of the information field are fixed to 0x000_0000;

a synchronization header of the D code block is 01; and

the E code block is the 64B/66B code block other than the S code block, the T code block, the C code block, and the D code block.

It can be understood that the 64B/66B coded signal in the embodiments of the present disclosure is composed of any combination of S code blocks, T code blocks, C code blocks, D code blocks, or E code blocks, and the types of 64B/66B code blocks included in the 64B/66B coded signal and the number of 64B/66B code blocks of each type are not particularly limited in the embodiments of the present disclosure.

At S102, the T code block is found and check information is generated according to a preset scheme.

Determining a check data area corresponding to the check information according to the T code block, where a length of the check data area is N*66+10 bits, N is an integer greater than 1, and last 10 bits of the check data area are first 10 bits of the 1st 64B/66B code block after the T code block; finding a 1st S code block before the T code block, where a 1st 64B/66B code block after the found 1st S code block before the T code block is a starting position of the check data area, and N 64B/66B code blocks are included from the starting position of the check data area to the T code block; and generating the check information of 24 bits in the check data area according to a BIP-24 algorithm or a CRC-24 algorithm; or generating the check information of 32 bits in the check data area according to a BIP-32 algorithm or a CRC-32 algorithm.

It can be understood that finding the T code block includes finding every T code block in the 64B/66B coded signal.

It can be understood that the check data area corresponding to the check information determined in this step should correspond to one MAC frame, and the check is performed for 64B/66B code blocks, i.e., the check range includes every bit of a plurality of 64B/66B code blocks. The check data area corresponding to the check information determined in this step is shown in FIG. 5. In FIG. 5, a 64B/66B code block currently being sent is a T code block, on the left side of the T code block are 64B/66B code block having already been sent, a 1st 64B/66B code block on the left side of the T code block is a 1st 64B/66B code block before the T code block, a 2nd 64B/66B code block on the left side of the T code block is a 2nd 64B/66B code block before the T code block, ..., and an Nth 64B/66B code block on the left side of the T code block is an Nth 64B/66B code block before the T code block, where, N is an integer greater than 1. Starting from the T code block, every 64B/66B code block is searched forward in sequence until the 1st S code block is found. Assuming that the S code block is the Nth code block before the T code block, all code blocks between the S and T code blocks are D code blocks under normal circumstances. On the right side of the T code block is a 64B/66B code block to be sent. A 1st 64B/66B code block on the right side of the T code block is a 1st 64B/66B code block after the T code block. According to step S103, the 1st 64B/66B code block on the right side of the T code block must be an S code block or a first preset code block. The 1st 64B/66B code block on the right side of the T code block in FIG. 5 is an S code block. The starting position of the check data area corresponding to the check information determined in this step is an (N-1)th 64B/66B code block on the left side of the T code block, and the ending position of the check data area is first 10 bits of the 1st 64B/66B code block on the right side of the T code block. The check data area includes N*66+10 bits, i.e., N 64B/66B code blocks plus 10 bits. See FIG. 5 for specific positions.

It can be understood that check information of 24 bits or check information of 32 bits may be generated in this step. If the first preset code block is the check C-O code block, check information of 24 bits is generated in this step. If the first preset code block is the D code block, check information of 32 bits is generated in this step.

A specific method of generating the check information of 24 bits is as follows.

The check data area corresponding to the check information determined in this step includes 66*N+10 bits in total, and the 66*N+10 bits are grouped according to continuous 24 bits, i.e., the first 24 bits are grouped into a 1st group, 25th to 48th bits are grouped into a 2nd group, 49th to 72nd bits are grouped into a 3rd group, and so on, thus obtaining INT((66*N+10)/24) data groups, where INT(A) represents rounding a decimal A, with a remainder being mod(66*N+10, 24), where mod(B, C) represents the remainder after B is divided by C, where B and C are both integers. If mod(66*N+10, 24) is equal to 0, INT((66*N+10)/24) data groups are finally obtained. If mod(66*N+10, 24) is not equal to 0, 24-mod(66*N+10, 24) bits of 0 are added to finally obtain INT((66*N+10)/24)+1 data groups. As such, an integer number of data groups are finally obtained, where each data group corresponds to 24 bits.

It can be understood that for the above integer number of data groups each corresponding to 24 bits, a BIP-24 algorithm can be used to generate check information of 24 bits. A specific implementation of the BIP-24 algorithm is to perform an XOR operation on the integer number of data groups, i.e., the first data group XOR the second data group XOR the third data group ... XOR the last data group, and using the result of the XOR operation as the check information of 24 bits.

It can be understood that for the above integer number of data groups each corresponding to 24 bits, a CRC-24 algorithm may also be used to generate check information of 24 bits. A generator polynomial of the CRC-24 algorithm may be:

$$G(x)=x^{24}+x^{23}+x^6+x^5+x+1.$$

A specific manner of generating check information using the CRC-24 algorithm is as follows.

Assuming that data to be checked includes K*24 bits, K being an integer greater than 1, w=K*24 is set, a polynomial M(x) of order w-1 is generated according to w bits, and w bits are used as coefficients of the polynomial M(x), where a 1st bit of the w bits is used as a coefficient of $x^{w-1}$, a 2nd bit of the w bits is used as a coefficient of $x^{w-2}$, a 3rd bit of the w bits is used as a coefficient of $x^{w-3}$, ..., and a wth bit of the w bits is used as a coefficient of $x^0$. The polynomial M(x) is multiplied by $x^{32}$ and then divided by a generator polynomial G(x) according to modulo 2 division to obtain a remainder polynomial R(x), where a maximum coefficient of the remainder polynomial is less than or equal to 23. A 24-bit value is obtained as the check information of 24 bits according to the coefficients of the remainder polynomial R(x).

A specific method of generating the check information of 32 bits is as follows.

The check data area corresponding to the check information determined in this step includes 66*N+10 bits in total, and the 66*N+10 bits are grouped according to continuous 32 bits, i.e., the first 32 bits are grouped into a 1st group, 33rd to 64th bits are grouped into a 2nd group, 65th to 96th bits are grouped into a 3rd group, and so on, thus obtaining INT((66*N+10)/32) data groups, with a remainder being mod(66*N+10, 32). If mod(66*N+10, 32) is equal to 0, INT((66*N+10)/32) data groups are finally obtained. If mod(66*N+10, 32) is not equal to 0, 32-mod(66*N+10, 32) bits of 0 are added to finally obtain INT((66*N+10)/32)+1 data groups. As such, an integer number of data groups are finally obtained, where each data group corresponds to 32 bits.

It can be understood that for the above integer number of data groups each corresponding to 32 bits, a BIP-32 algorithm can be used to generate check information of 32 bits. A specific implementation of the BIP-32 algorithm is to perform an XOR operation on the integer number of data groups, i.e., the first data group XOR the second data group XOR the third data group ... XOR the last data group, and using the result of the XOR operation as the check information of 32 bits.

It can be understood that for the above integer number of data groups each corresponding to 32 bits, a CRC-32 algorithm may also be used to generate check information of 32 bits. A generator polynomial of the CRC-32 algorithm may be:

$$G(x)= x^{32}+ x^{26}+ x^{23}+ x^{22}+ x^{16}+ x^{12}+ x^{11}+ x^{10}+ x^8+ x^7+ x^5+ x^4+ x^2+ x+ 1.$$

A specific manner of generating check information using the CRC-32 algorithm is as follows.

Assuming that data to be checked includes K*32 bits, K being an integer greater than 1, w=K*32 is set, a polynomial M(x) of order w-1 is generated according to w bits, and w bits are used as coefficients of the polynomial M(x), where a 1st bit of the w bits is used as a coefficient of $x^{w-1}$, a 2nd bit of the w bits is used as a coefficient of $x^{w-2}$, a 3rd bit of the w bits is used as a coefficient of $x^{w-3}$, ..., and a wth bit of the w bits is used as a coefficient of $x^0$. The polynomial M(x) is multiplied by $x^{32}$ and then divided by a generator polynomial G(x) according to modulo 2 division to obtain a remainder polynomial R(x), where a maximum coefficient of the remainder polynomial is less than or equal to 31. A 32-bit value is obtained as the check information of 32 bits according to the coefficients of the remainder polynomial R(x).

At S103, the check information is written into a 1st 64B/66B code block after the T code block.

It can be understood that if the 1st 64B/66B code block after the T code block is the S code block, keeping the 1st 64B/66B code block after the T code block unchanged;

if the 1st 64B/66B code block after the T code block is the C-I code block, replacing the 1st 64B/66B code block after the T code block with a first preset code block;

if the 1st 64B/66B code block after the T code block is neither the S code block nor the C-I code block, adding one first preset code block after the T code block, and incrementing a first addition counter by 1, where the first addition counter records a number of first preset code blocks added, and an initial value of the first addition counter is 0;

after the processing, the 1st 64B/66B code block after the T code block is the S code block or the first preset code block; and writing the check information into the S code block or the first preset code block.

When the C-I code block is found and a 1st 64B/66B code block before the found C-I code block is not the T code block, it is checked whether the first addition counter is 0; if the first addition counter is 0, no processing is performed; and if the first addition counter is not 0, the found C-I code block is deleted, and the first addition counter is decremented by 1.

The first preset code block may be a check C-O code block or a D code block, where the check C-O code block is the C-O code block, the type of the ordered set control information in a 56-bit information field of the check C-O code block is a first preset value, and the first preset value is 4-bit information for distinguishing types of other ordered set control information already defined.

When the first preset code block is the check C-O code block, the content of the ordered set control information in the 56-bit information field of the check C-O code block is used for storing the check information of 24 bits. Writing the check information into the S code block or the first preset code block includes writing the check information of 24 bits into the content of the ordered set control information in the 56-bit information field of the check C-O code block or writing the check information of 24 bits into 1st to 24th bits of a 56-bit information field of the S code block.

When the first preset code block is the D code block, 1st to 32nd bits of the block payload of the D code block are used for storing the check information, 33rd to 64th bits of the block payload are fixed to 0. Writing the check information into the S code block or the first preset code block includes writing the check information of 32 bits into the 1st to 32nd bits of the block payload of the D code block or writing the check information of 32 bits into 1st to 32nd bits of a 56-bit information field of the S code block.

It can be understood that in the C-O code block, the type of the ordered set control information occupies 4 bits, so there are at most 16 types of ordered set control information. At present, IEEE 802.3 has only defined two ordered set control types: sequence ordered sets and signal ordered sets. A new control type is defined and named check ordered sets. A specific 4-bit value is assigned to label the check ordered set, and a 64B/66B code block corresponding to the check ordered set is named check C-O code block. Since the C-O code block also includes the content of the ordered set control information which is 24 bits, check information of 24 bits may be defined in the check C-O code block.

It should be noted that when the T code block is followed by two exactly identical C-O code blocks, i.e., two C-O code blocks having the same content in the 56-bit information field, one of the C-O code blocks may be deleted according to Ethernet standards, so the 1st C-O code block after the T code block may be replaced with the first preset code block.

It can be understood that in the above processing, in some cases, one first preset code block needs to be added after the T code block, resulting in an additional 64B/66B code block. In such cases, it is necessary to use the first addition counter to record this addition operation, and subsequently delete one C-I code block once an appropriate C-I code block is found, to ensure that the total number of 64B/66B code blocks remains unchanged.

At S104, the 64B/66B coded signal is sent.

It can be understood that the sending of the 64B/66B coded signal may be implemented in a variety of manners, including at least the following manners:

sending the 64B/66B coded signal over a physical medium; or

encapsulating the 64B/66B coded signal into a service signal and sending the service signal; or

converting the 64B/66B coded signal into a coded signal of another format, and sending the coded signal of the another format.

Steps S107 to S109 are executed at the receive end.

At S107, the 64B/66B coded signal sent by the transmit end is received.

It can be understood that the 64B/66B coded signal received in this step is the 64B/66B coded signal sent in step S104. Corresponding to the variety of methods of sending the 64B/66B coded signal in step S104, this step includes a variety of implementation methods:

receiving, through a physical medium, the 64B/66B coded signal sent by the transmit end; or

receiving the service signal sent by the transmit end, and extracting the 64B/66B coded signal from the service signal; or

receiving the coded signal of the another format sent by the transmit end, and converting the coded signal of the another format into the 64B/66B coded signal.

At S108, the T code block is found and the check information is acquired according to the T code block.

It can be understood that finding the T code blocks includes finding every T code block in the 64B/66B coded signal received in step S107.

It can be understood that this step includes different implementation methods depending on whether the first preset code block is a check C-O code block or the D code block:
when the first preset code block is the check C-O code block:

if it is detected that the 1st 64B/66B code block after the T code block is the check C-O code block, acquiring the check information of 24 bits from the content of the ordered set control information in the 56-bit information field of the check C-O code block; and

if it is detected that the 1st 64B/66B code block after the T code block is the S code block, acquiring the check information of 24 bits from the 1st to 24th bits of the 56-bit information field of the S code block; and

when the first preset code block is the D code block:

if it is detected that the 1st 64B/66B code block after the T code block is the D code block, acquiring the check information of 32 bits from the 1st to 32nd bits of the block payload of the D code block; and

if it is detected that the 1st 64B/66B code block after the T code block is the S code block, acquiring the check information of 32 bits from the 1st to 32nd bits of the 56-bit information field of the S code block.

It can be understood that this step is executed at the receive end, and for the 1st 64B/66B code block after the T code block, the term "after" is relative to a receiving direction. Assuming that a T code block is currently being received, according to a receiving order, a 64B/66B code block having already been received corresponds to "before", and a 64B/66B code block to be received corresponds to "after", i.e., a previous 64B/66B code block having been received corresponds to the 1st code block before the T code block, and a next 64B/66B code block to be received corresponds to the 1st code block after the T code block. As shown in FIG. 6, a T code block is currently being received, a previous 64B/66B code block having been received is a D code block, and a next 64B/66B code block to be received is a check CO code block. In this case, the 1st code block before the T code block is the D code block, and the 1st code block after the T code block is the check C-O code block.

At S109, it is detected according to the check information whether a check error exists, and a subset of the 64B/66B code blocks is replaced depending on whether a check error exists.

It can be understood that detecting according to the check information whether a check error exists includes:

determining a check data area corresponding to the check information according to the T code block, where a length of the check data area is $N*66+10$ bits, $N$ is an integer greater than 1, and last 10 bits of the check data area are first 10 bits of the 1st 64B/66B code block after the T code block; finding a 1st S code block before the T code block, where a 1st 64B/66B code block after the found 1st S code block before the T code block is a starting position of the check data area, and $N$ 64B/66B code blocks are included from the starting position of the check data area to the T code block;

if the first preset code block is the check C-O code block, regenerating 24-bit second check information according to a BIP-24 algorithm or a CRC-24 algorithm in the check data area corresponding to the check information, comparing the 24-bit second check information with the check information of 24 bits, determining that no check error exists if the 24-bit second check information is equal to the check information of 24 bits, and determining that a check error exists if the 24-bit second check information is not equal to the check information of 24 bits; and

if the first preset code block is the D code block, regenerating 32-bit third check information according to a BIP-32 algorithm or a CRC-32 algorithm in the check data area corresponding to the check information, comparing the 32-bit third check information with the check information of 32 bits, determining that no check error exists if the 32-bit third check information is equal to the check information of 32 bits, and determining that a check error exists if the 32-bit third check information is not equal to the check information of 32 bits.

It can be understood that this step further includes:
when the first preset code block is the check C-O code block:

if it is detected that the 1st 64B/66B code block after the T code block is the S code block and detected according to the check information in the S code block that no check error exists, writing 7 bytes of 0xaa into the 56-bit information field of the S code block;

if it is detected that the 1st 64B/66B code block after the T code block is the S code block and detected according to the check information in the S code block that a check error exists, replacing a $P^{th}$ 64B/66B code block before the T code block with a 64B/66B code block representing error information, and writing 7 bytes of 0xaa into the 56-bit information field of the S code block, where $P$ is an integer greater than or equal to 0;

if it is detected that the 1st 64B/66B code block after the T code block is the check C-O code block and detected according to the check information in the check C-O code block that no check error exists, replacing the check C-O code block with the C-I code block;

if it is detected that the 1st 64B/66B code block after the T code block is the check C-O code block and detected according to the check information in the check C-O code block that a check error exists, replacing a Pth 64B/66B code block before the T code block with a 64B/66B code block representing error information, and replacing the check C-O code block with the C-I code block; and

if it is detected that the 1st 64B/66B code block after the T code block is neither the S code block nor the check C-O code block, replacing a Pth 64B/66B code block before the T code block with a 64B/66B code block representing error information; and

when the first preset code block is the D code block:

if it is detected that the 1st 64B/66B code block after the T code block is the S code block and detected according to the check information in the S code block that no check error exists, writing 7 bytes of 0xaa into the 56-bit information field of the S code block;

if it is detected that the 1st 64B/66B code block after the T code block is the S code block and detected according to the check information in the S code block that a check error exists, replacing a Pth 64B/66B code block before the T code block with a 64B/66B code block representing error information, and writing 7 bytes of 0xaa into the 56-bit information field of the S code block, where P is an integer greater than or equal to 0;

if it is detected that the 1st 64B/66B code block after the T code block is the D code block and detected according to the check information in the D code block that no check error exists, replacing the D code block with the C-I code block;

if it is detected that the 1st 64B/66B code block after the T code block is the D code block and detected according to the check information in the D code block that a check error exists, replacing a Pth 64B/66B code block before the T code block with a 64B/66B code block representing error information, and replacing the D code block with the C-I code block; and

if it is detected that the 1st 64B/66B code block after the T code block is neither the S code block nor the D code block, replacing a Pth 64B/66B code block before the T code block with a 64B/66B code block representing error information.

It can be understood that replacing a Pth 64B/66B code block before the T code block with a 64B/66B code block representing error information includes the following four error replacement actions:

a first error replacement action: where P is 0, i.e., the T code block is replaced with the 64B/66B code block representing the error information, where the 64B/66B code block representing the error information has a synchronization header of 10, a type field of 0x1e, an information field including 8 error control characters, and the error control character is 7 bits of 0x1e;

a second error replacement action: where P is 0, i.e., the T code block is replaced with the 64B/66B code block representing the error information, where the 64B/66B code block representing the error information has a synchronization header of 00 or 11 and a block payload of 64 bits of 0;

a third error replacement action: where P is 1, i.e., the 1st 64B/66B code block before the T code block is replaced with the 64B/66B code block representing the error information, where the 64B/66B code block representing the error information has a synchronization header of 10, a type field of 0x1e, an information field including 8 error control characters, and the error control character is 7 bits of 0x1e; and

a fourth error replacement action: where P is 1, i.e., the 1st 64B/66B code block before the T code block is replaced with the 64B/66B code block representing the error information, where the 64B/66B code block representing the error information has a synchronization header of 00 or 11 and a block payload of 64 bits of 0.

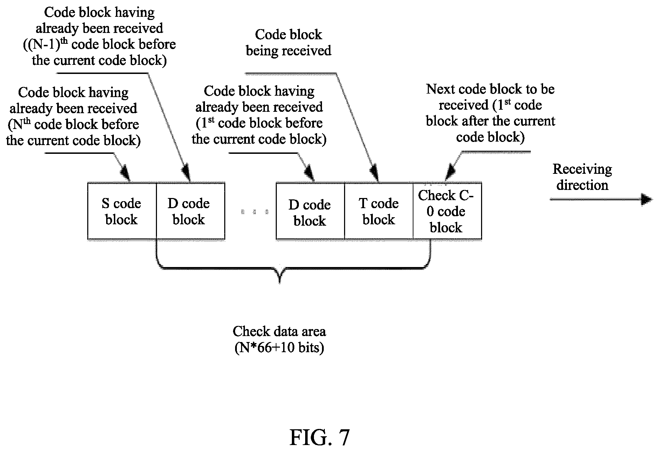

It can be understood that the check data area corresponding to the check information determined in this step is similar to that in step S102. As shown in FIG. 7, it is assumed that a 64B/66B code block currently being received is a T code block, a 1st 64B/66B code block on the left side of the T code block is a 1st 64B/66B code block before the T code block, a 2nd 64B/66B code block on the left side of the T code block is a 2nd 64B/66B code block before the T code block, ..., and an Nth 64B/66B code block on the left side of the T code block is an Nth 64B/66B code block before the T code block, where, N is an integer greater than 1. Starting from the T code block, every 64B/66B code block is searched forward in sequence until the 1st S code block is found. Assuming that the S code block is the Nth code block before the T code block, all code blocks between the S and T code blocks are D code blocks under normal circumstances. On the right side of the T code block is a 64B/66B code block to be received. A 1st 64B/66B code block on the right side of the T code block is a 1st 64B/66B code block after the T code block. According to FIG. 7, the 1st 64B/66B code block on the right side of the T code block is a check C-O code block. The starting position of the check data area corresponding to the check information is an $(N-1)^{th}$ 64B/66B code block on the left side of the T code block, and the ending position of the check data area is first 10 bits of the 1st 64B/66B code block on the right side of the T code block. The check data area includes N*66+10 bits, i.e., N 64B/66B code blocks plus 10 bits. See FIG. 7 for specific positions.

It can be understood that when the second check information of 24 bits is regenerated according to the BIP-24 algorithm or the CRC-24 algorithm, a specific implementation of the BIP-24 algorithm or the CRC-24 algorithm is as described in step S102. The length of the check data area corresponding to the check information is N*66+10 bits. First, a maximum of 23 bits of 0 is added after the N*66+10 bits, to extend to 24*K bits, where K is an integer greater than 1. Then, the second check information of 24 bits is generated for the 24*K bits according to the BIP-24 algorithm or the CRC-24 algorithm in step S102. The second check information of 24 bits is compared with the 24-bit check information in the 56-bit information field of the S code block or the check C-O code block. If the second check information is equal to the 24-bit check information, it is determined that no check error occurs. If the second check information is not equal to the 24-bit check information, it is determined that a check error occurs.

It can be understood that when the third check information of 32 bits is regenerated according to the BIP-32 algorithm or the CRC-32 algorithm, a specific implementation of the BIP-32 algorithm or the CRC-32 algorithm is as described in step S102. The length of the check data area corresponding to the check information is N*66+10 bits. First, a maximum of 31 bits of 0 is added after the N*66+10 bits to extend the length to 32*K bits, where K is an integer greater than 1. Then, the third check information of 32 bits is generated for the 32*K bits according to the BIP-32 algorithm or the CRC-32 algorithm in step S102. The third check information of 32 bits is compared with the 32-bit check information in the 56-bit information field of the S code block or with the 32-bit check information in the 64-bit block payload of the D code block. If the third check information is equal to the 32-bit check information, it is determined that no check error occurs. If the third check information is not equal to the 32-bit check information, it is determined that a check error occurs.

It can be understood that the effect of replacing the Pth 64B/66B code block before the T code block with the 64B/66B code block representing the error information is to delete the end-of-frame flag of the MAC frame, so that the MAC frame with the error will be discarded in subsequent processing due to failing to find the end-of-frame flag of the MAC frame.

It can be further understood that when it is detected according to the check information in the D code block that a check error exists, it means that there is an error in the MAC frame, and the MAC frame with the error should be discarded. The T code block may be replaced with the 64B/66B code block representing the error information, so that the MAC frame with the error can be discarded. However, according to a processing method of extracting a MAC frame from a 64B/66B coded signal defined in IEEE 802.3, the 1st 64B/66B code block after the T code block will also be considered as an erroneous 64B/66B code block. If the 1st 64B/66B code block after the T code block is an S code block, this S code block will also be discarded. As a result, two consecutive MAC frames are discarded. However, in this case, there is a very low probability that the MAC frame where the S code block is located has an error, and discarding the MAC frame where the S code block is located is likely to result in the discarding of a correct MAC frame. Therefore, to avoid discarding the MAC frame where the S code block is located, the 1st 64B/66B code block before the T code block may be replaced with an erroneous 64B/66B code block. In this way, during the extraction of the MAC frame from the 64B/66B coded signal, the T code block and the 1st 64B/66B code block before the T code block are considered to be erroneous 64B/66B code blocks, so that only the MAC frame where the T code block is located will be discarded, and the MAC frame corresponding to the S code block after the T code block will not be discarded. When the T code block or the 1st 64B/66B code block before the T code block is replaced with the 64B/66B code block representing the error information, the 64B/66B code block representing the error information may also be implemented in a variety of manners. The 64B/66B code block representing the error information may be a 64B/66B code block having a synchronization header of 10, a type field of 0x1e, and an information field including 8 error control characters, where the error control character is 7 bits of 0x1e. The 64B/66B code block representing the error information may be a 64B/66B code block having a synchronization header of 00 or 11 and a block payload of 64 bits of 0.

It can be further understood that based on the above, a main function of step S107 includes: acquiring the check information after the T code block, detecting according to the check information whether a check error exists, and if a check error exists, replacing the T code block or the 1st 64B/66B code block before the T code block with the 64B/66B code block representing the error information, so that the MAC frame corresponding to the T code block will be discarded.

Another embodiment of the present disclosure provides a 64B/66B coded signal processing method. In the embodiment of the present disclosure, this method includes executing the following steps S201 to S204 at a transmit end and executing the following steps S207 to S209 at a receive end, which will be sequentially described below.

Steps S201 to S204 are executed at the transmit end.

At S201, a 64B/66B coded signal is acquired, where the 64B/66B coded signal is composed of 64B/66B code blocks.

The 64B/66B code blocks include at least one of an S code block, a T code block, a C code block, a D code block, or an E code block.

It can be understood that the 64B/66B code blocks each include a 2-bit synchronization header and a 64-bit block payload, the block payload includes an 8-bit type field and a 56-bit information field when the 2-bit synchronization header is 10, and the block payload includes a 64-bit information field when the 2-bit synchronization header is 01;

a synchronization header of the S code block is 10, a type field of the S code block includes a start-of-frame flag, and the start-of-frame flag is 0x78;

a synchronization header of the T code block is 10, a type field of the T code block includes an end-of-frame flag, and the end-of-frame flag is one of 0x87, 0x99, 0xaa, 0xb4, 0xcc, 0xd2, Oxel or 0xff;

the C code block includes a C-I code block and a C-O code block, where a synchronization header of the C-I code block is 10, a type field of the C-I code block is Oxle, an information field of the C-I code block includes 8 idle control characters, and the idle control character is 7 bits of 0; a synchronization header of the C-O code block is 10, a type field of the C-O code block is 0x4b, first 28 bits of an information field of the C-O code block include a content and a type of ordered set control information, and last 28 bits of the information field are fixed to 0x000_0000;

a synchronization header of the D code block is 01; and

the E code block is the 64B/66B code block other than the S code block, the T code block, the C code block, and the D code block.

It can be understood that the 64B/66B coded signal in the embodiments of the present disclosure is composed of any combination of S code blocks, T code blocks, C code blocks, D code blocks, or E code blocks, and the types of 64B/66B code blocks included in the 64B/66B coded signal and the number of 64B/66B code blocks of each type are not particularly limited in the embodiments of the present disclosure.

At S202, the T code block is found and check information is generated according to a preset scheme.

Determining a check data area corresponding to the check information according to the T code block, where a length of the check data area is N*66+10 bits, N is an integer greater than 1, and last 10 bits of the check data area are first 10 bits of the 1st 64B/66B code block after the T code block; finding a 1st S code block before the T code block, where a 1st 64B/66B code block after the found 1st S code block before the T code block is a starting position of the check data area, and N 64B/66B code blocks are included from the starting position of the check data area to the T code block; and generating the check information of 32 bits in the check data area according to a BIP-32 algorithm or a CRC-32 algorithm.

It can be understood that finding the T code block includes finding every T code block in the 64B/66B coded signal.

It can be understood that this step is executed at the transmit end, and for the 1st 64B/66B code block after the T code block, the term "after" is relative to a sending direction. Assuming that a T code block is currently being sent, according to a sending order, a 64B/66B code block having already been sent corresponds to "before", and a 64B/66B code block to be sent corresponds to "after".

It can be understood that the check data area corresponding to the check information determined in this step should correspond to one MAC frame, and the check is performed for 64B/66B code blocks, i.e., the check range includes every bit of a plurality of 64B/66B code blocks. The check data area corresponding to the check information determined in this step is similar to that in step S102. Assuming that the 64B/66B code block currently being sent is a T code block, every 64B/66B code block is searched forward in sequence starting from the T code block until the 1st S code block is found. Assuming that the S code block is the Nth code block before the T code block, the starting position of the check data area corresponding to the check information is an (N-1)th 64B/66B code block before the T code block, and the ending position of the check data area is first 10 bits of the 1st 64B/66B code block after the T code block. The check data area includes N*66+10 bits, i.e., N 64B/66B code blocks plus 10 bits.

It can be understood that a specific method of generating the check information of 32 bits in this step is as follows.

The check data area corresponding to the check information determined in this step includes 66*N+10 bits in total, and the 66*N+10 bits are grouped according to continuous 32 bits, i.e., the first 32 bits are grouped into a 1st group,

33$^{rd}$ to 64$^{th}$ bits are grouped into a 2$^{nd}$ group, 65$^{th}$ to 96$^{th}$ bits are grouped into a 3$^{rd}$ group, and so on, thus obtaining INT((66*N+10)/32) data groups, with a remainder being mod(66*N+10, 32). If mod(66*N+10, 32) is equal to 0, INT((66*N+10)/32) data groups are finally obtained. If mod(66*N+10, 32) is not equal to 0, 32-mod(66*N+10, 32) bits of 0 are added to finally obtain INT((66*N+10)/32)+1 data groups. As such, an integer number of data groups are finally obtained, where each data group corresponds to 32 bits.

It can be understood that for the above integer number of data groups each corresponding to 32 bits, a BIP-32 algorithm can be used to generate check information of 32 bits. A specific implementation of the BIP-32 algorithm is to perform an XOR operation on the integer number of data groups, i.e., the first data group XOR the second data group XOR the third data group ... XOR the last data group, and using the result of the XOR operation as the check information of 32 bits.

It can be understood that for the above integer number of data groups each corresponding to 32 bits, a CRC-32 algorithm may also be used to generate check information of 32 bits. A generator polynomial of the CRC-32 algorithm may be:

$$G(x)= x^{32}+ x^{26}+ x^{23}+ x^{22}+ x^{16}+ x^{12}+ x^{11}+ x^{10}+ x^{8}+ x^{7}+ x^{5}+ x^{4}+ x^{2}+ x+ 1.$$

A specific manner of generating check information using the CRC-32 algorithm is as follows.

Assuming that data to be checked includes K*32 bits, K being an integer greater than 1, w=K*32 is set, a polynomial M(x) of order w-1 is generated according to w bits, and w bits are used as coefficients of the polynomial M(x), where a 1$^{st}$ bit of the w bits is used as a coefficient of $x^{w-1}$, a 2$^{nd}$ bit of the w bits is used as a coefficient of $x^{w-2}$, a 3$^{rd}$ bit of the w bits is used as a coefficient of $x^{w-3}$, ..., and a w$^{th}$ bit of the w bits is used as a coefficient of $x^{0}$. The polynomial M(x) is multiplied by $x^{32}$ and then divided by a generator polynomial G(x) according to modulo 2 division to obtain a remainder polynomial R(x), where a maximum coefficient of the remainder polynomial is less than or equal to 31. A 32-bit value is obtained as the check information of 32 bits according to the coefficients of the remainder polynomial R(x).

At S203, the check information is written into a 1$^{st}$ 64B/66B code block after the T code block.

It can be understood that if the 1$^{st}$ 64B/66B code block after the T code block is the S code block, keeping the 1$^{st}$ 64B/66B code block after the T code block unchanged;

if the 1$^{st}$ 64B/66B code block after the T code block is not the S code block, replacing the 1$^{st}$ 64B/66B code block after the T code block with a second preset code block, and writing partial information of the 1$^{st}$ 64B/66B code block after the T code block into the second preset code block;

after the processing, the 1$^{st}$ 64B/66B code block after the T code block is the S code block or the second preset code block; and writing the check information into the S code block or the second preset code block.

The second preset code block may be the D code block, where 1$^{st}$ to 32$^{nd}$ bits of the block payload of the D code block are used for storing the check information, 33$^{rd}$ to 36$^{th}$ bits of the block payload are used for storing a coding type of the replaced 64B/66B code block, and 37$^{th}$ to 64$^{th}$ bits of the block payload are used for storing partial information of the replaced 64B/66B code block.

It can be understood that if the 1$^{st}$ 64B/66B code block after the T code block is not the S code block, replacing the 1$^{st}$ 64B/66B code block after the T code block with a second preset code block, and writing partial information of the 1$^{st}$ 64B/66B code block after the T code block into the second preset code block includes:

if the 1$^{st}$ 64B/66B code block after the T code block is the C-I code block, simultaneously writing a value of 1 into the 33$^{rd}$ to 36$^{th}$ bits of the block payload in the D code block;

if the 1$^{st}$ 64B/66B code block after the T code block is the C-O code block, simultaneously writing a value of 2 into the 33$^{rd}$ to 36$^{th}$ bits of the block payload in the D code block, and simultaneously writing 1$^{st}$ to 28$^{th}$ bits of the information field of the C-O code block into the 37$^{th}$ to 64$^{th}$ bits of the block payload in the D code block; and

if the 1$^{st}$ 64B/66B code block after the T code block is one of the T code block, the D code block, or the E code block, simultaneously writing a value of 3 into the 33$^{rd}$ to 36$^{th}$ bits of the block payload in the D code block.

Writing the check information of 32 bits into the 1$^{st}$ to 32$^{nd}$ bits of the block payload of the D code block or writing the check information of 32 bits into 1$^{st}$ to 32$^{nd}$ bits of a 56-bit information field of the S code block.

It should be noted that when the T code block is followed by two exactly identical C-O code blocks, i.e., two C-O code blocks having the same content in the 56-bit information field, one of the C-O code blocks may be deleted according to Ethernet standards, or the 1$^{st}$ C-O code block after the T code block may be replaced with the second preset code block.

At S204, the 64B/66B coded signal is sent.

It can be understood that the sending of the 64B/66B coded signal may be implemented in a variety of manners, including at least the following manners:

sending the 64B/66B coded signal over a physical medium; or

encapsulating the 64B/66B coded signal into a service signal and sending the service signal; or

converting the 64B/66B coded signal into a coded signal of another format, and sending the coded signal of the another format.

Steps S207 to S209 are executed at the receive end.

At S207, the 64B/66B coded signal sent by the transmit end is received.

It can be understood that the 64B/66B coded signal received in this step is the 64B/66B coded signal sent in step S204. Corresponding to the variety of methods of sending the 64B/66B coded signal in step S204, this step includes a variety of implementation methods:

receiving, through a physical medium, the 64B/66B coded signal sent by the transmit end; or

receiving the service signal sent by the transmit end, and extracting the 64B/66B coded signal from the service signal; or

receiving the coded signal of the another format sent by the transmit end, and converting the coded signal of the another format into the 64B/66B coded signal.

At S208, the T code block is found and the check information is acquired according to the T code block.

It can be understood that finding the T code blocks includes finding every T code block in the 64B/66B coded signal received in step S207.

It can be understood that if it is detected that the $1^{st}$ 64B/66B code block after the T code block is the D code block, acquiring the check information of 32 bits from the $1^{st}$ to $32^{nd}$ bits of the block payload of the D code block; and if it is detected that the $1^{st}$ 64B/66B code block after the T code block is the S code block, acquiring the check information of 32 bits from the $1^{st}$ to $32^{nd}$ bits of the 56-bit information field of the S code block.

It can be understood that this step is executed at the receive end, and for the $1^{st}$ 64B/66B code block after the T code block, the term "after" is relative to a receiving direction. Assuming that a T code block is currently being received, according to a receiving order, a 64B/66B code block having already been received corresponds to "before", and a 64B/66B code block to be received corresponds to "after".

At S209, it is detected according to the check information whether a check error exists, and a subset of the 64B/66B code blocks is replaced depending on whether a check error exists.

It can be understood that detecting according to the check information whether a check error exists includes:

determining a check data area corresponding to the check information according to the T code block, where a length of the check data area is N*66+10 bits, N is an integer greater than 1, and last 10 bits of the check data area are first 10 bits of the $1^{st}$ 64B/66B code block after the T code block; finding a $1^{st}$ S code block before the T code block, where a $1^{st}$ 64B/66B code block after the found $1^{st}$ S code block before the T code block is a starting position of the check data area, and N 64B/66B code blocks are included from the starting position of the check data area to the T code block; and

regenerating 32-bit fourth check information according to a BIP-32 algorithm or a CRC-32 algorithm in the check data area corresponding to the check information, comparing the 32-bit fourth check information with the check information of 32 bits, determining that no check error exists if the 32-bit fourth check information is equal to the check information of 32 bits, and determining that a check error exists if the 32-bit fourth check information is not equal to the check information of 32 bits.

It can be understood that this step further includes:

if it is detected that the $1^{st}$ 64B/66B code block after the T code block is the S code block and detected according to the check information in the S code block that no check error exists, writing 7 bytes of 0xaa into the 56-bit information field of the S code block;

if it is detected that the 1st 64B/66B code block after the T code block is the S code block and detected according to the check information in the S code block that a check error exists, replacing a $P^{th}$ 64B/66B code block before the T code block with a 64B/66B code block representing error information, and writing 7 bytes of 0xaa into the 56-bit information field of the S code block, where P is an integer greater than or equal to 0;

if it is detected that the 1st 64B/66B code block after the T code block is the D code block and detected according to the check information in the D code block that no check error exists, detecting the $33^{rd}$ to $36^{th}$ bits of the block payload of the D code block; if the $33^{rd}$ to $36^{th}$ bits is a value of 1, replacing the D code block with the C-I code block; if the $33^{rd}$ to $36^{th}$ bits is a value of 2, replacing the D code block with the C-O code block, and writing the $37^{th}$ to $64^{th}$ bits of the block payload of the D code block into the 1st to $28^{th}$ bits of the information field of the C-O code block; if the $33^{rd}$ to $36^{th}$ bits is neither a value of 1 nor a value of 2, replacing the D code block with a 64B/66B code block including 8 error control characters, where the 64B/66B code block including the 8 error control characters has a synchronization header of 10, a type field of 0x1e, and an information field including the 8 error control characters, and the error control character is 7 bits of 0x1e;

if it is detected that the 1st 64B/66B code block after the T code block is the D code block and detected according to the check information in the D code block that a check error exists, replacing a $P^{th}$ 64B/66B code block before the T code block with a 64B/66B code block representing error information, and detecting the $33^{rd}$ to $36^{th}$ bits of the block payload of the D code block; if the $33^{rd}$ to $36^{th}$ bits is a value of 1, replacing the D code block with the C-I code block; if the $33^{rd}$ to $36^{th}$ bits is a value of 2, replacing the D code block with the C-O code block, and writing the $37^{th}$ to $64^{th}$ bits of the block payload of the D code block into the 1st to $28^{th}$ bits of the information field of the C-O code block; if the $33^{rd}$ to $36^{th}$ bits is neither a value of 1 nor a value of 2, replacing the D code block with a 64B/66B code block including 8 error control characters, where the 64B/66B code block including the 8 error control characters has a synchronization header of 10, a type field of 0x1e, and an information field including the 8 error control characters, and the error control character is 7 bits of 0x1e; and

if it is detected that the 1st 64B/66B code block after the T code block is neither the S code block nor the D code block, replacing a $P^{th}$ 64B/66B code block before the T code block with a 64B/66B code block representing error information.

It can be understood that replacing a $P^{th}$ 64B/66B code block before the T code block with a 64B/66B code block representing error information includes the following four error replacement actions:

a first error replacement action: where P is 0, i.e., the T code block is replaced with the 64B/66B code block representing the error information, where the 64B/66B code block representing the error information has a synchronization header of 10, a type field of 0x1e, an information field including 8 error control characters, and the error control character is 7 bits of 0x1e;

a second error replacement action: where P is 0, i.e., the T code block is replaced with the 64B/66B code block representing the error information, where the 64B/66B code block representing the error information has a synchronization header of 00 or 11 and a block payload of 64 bits of 0;

a third error replacement action: where P is 1, i.e., the 1st 64B/66B code block before the T code block is replaced with the 64B/66B code block representing the error information, where the 64B/66B code block representing the error information has a synchronization header of 10, a type field of Oxle, an information field including 8 error control characters, and the error control character is 7 bits of 0x1e; and

a fourth error replacement action: where P is 1, i.e., the 1st 64B/66B code block before the T code block is replaced with the 64B/66B code block representing the error information, where the 64B/66B code block representing the error information has a synchronization header of 00 or 11 and a block payload of 64 bits of 0.

It can be understood that the check data area corresponding to the check information determined in this step is similar to that in step S109. Assuming that the 64B/66B code block currently being received is a T code block, every 64B/66B code block is searched forward in sequence starting from the T code block until the 1st S code block is found. Assuming that the S code block is the $N^{th}$ code block before the T code block, the starting position of the check data area corresponding to the check information is an $(N-1)^{th}$ 64B/66B code block before the T code block, and the ending position of the check data area is first 10 bits of the 1st 64B/66B code block after the T code block. The check data area includes N*66+10 bits, i.e., N 64B/66B code blocks plus 10 bits.

It can be understood that when the fourth check information of 32 bits is regenerated according to the BIP-32 algorithm or the CRC-32 algorithm, a specific implementation of the BIP-32 algorithm or the CRC-32 algorithm is as described in step S102. The length of the check data area corresponding to the check information is N*66+10 bits. First, a maximum of 31 bits of 0 is added after the N*66+10 bits to extend the length to 32*K bits, where K is an integer greater than 1. Then, the fourth check information of 32 bits is generated for the 32*K bits according to the BIP-32 algorithm or the CRC-32 algorithm in step S102. The fourth check information of 32 bits is compared with the 32-bit check information in the 56-bit information field of the S code block or with the 32-bit check information in the 64-bit block payload of the D code block. If the fourth check information is equal to the 32-bit check information, it is determined that no check error occurs. If the fourth check information is not equal to the 32-bit check information, it is determined that a check error occurs.

It can be understood that the effect of replacing the P$^{th}$ 64B/66B code block before the T code block with the 64B/66B code block representing the error information is to delete the end-of-frame flag of the MAC frame, so that the MAC frame with the error will be discarded in subsequent processing due to failing to find the end-of-frame flag of the MAC frame.

Another embodiment of the present disclosure provides a 64B/66B coded signal processing method. In the embodiment of the present disclosure, this method includes executing the following steps S301 to S304 at a transmit end and executing the following steps S307 to S309 at a receive end, which will be sequentially described below.

Steps S301 to S304 are executed at the transmit end.

At S301, a 64B/66B coded signal is acquired, where the 64B/66B coded signal is composed of 64B/66B code blocks.

The 64B/66B code blocks include at least one of an S code block, a T code block, a C code block, a D code block, or an E code block.

It can be understood that the 64B/66B code blocks each include a 2-bit synchronization header and a 64-bit block payload, the block payload includes an 8-bit type field and a 56-bit information field when the 2-bit synchronization header is 10, and the block payload includes a 64-bit information field when the 2-bit synchronization header is 01;

a synchronization header of the S code block is 10, a type field of the S code block includes a start-of-frame flag, and the start-of-frame flag is 0x78;

a synchronization header of the T code block is 10, a type field of the T code block includes an end-of-frame flag, and the end-of-frame flag is one of 0x87, 0x99, 0xaa, 0xb4, 0xcc, 0xd2, 0xe1 or 0xff;

the C code block includes a C-I code block and a C-O code block, where a synchronization header of the C-I code block is 10, a type field of the C-I code block is 0x1e, an information field of the C-I code block includes 8 idle control characters, and the idle control character is 7 bits of 0; a synchronization header of the C-O code block is 10, a type field of the C-O code block is 0x4b, first 28 bits of an information field of the C-O code block include a content and a type of ordered set control information, and last 28 bits of the information field are fixed to 0x000_0000;

a synchronization header of the D code block is 01; and

the E code block is the 64B/66B code block other than the S code block, the T code block, the C code block, and the D code block.

It can be understood that the 64B/66B coded signal in the embodiments of the present disclosure is composed of any combination of S code blocks, T code blocks, C code blocks, D code blocks, or E code blocks, and the types of 64B/66B code blocks included in the 64B/66B coded signal and the number of 64B/66B code blocks of each type are not particularly limited in the embodiments of the present disclosure.

At S302, the T code block is found and check information is generated according to a preset scheme.

Determining a check data area corresponding to the check information according to the T code block, where a length of the check data area is N*66+10 bits, N is an integer greater than 1, and last 10 bits of the check data area are first 10 bits of the 1$^{st}$ 64B/66B code block after the T code block; finding a 1$^{st}$ S code block before the T code block, where a 1$^{st}$ 64B/66B code block after the found 1$^{st}$ S code block before the T code block is a starting position of the check data area, and N 64B/66B code blocks are included from the starting position of the check data area to the T code block; and generating the check information of 24 bits in the check data area according to a BIP-24 algorithm or a CRC-24 algorithm.

It can be understood that finding the T code block includes finding every T code block in the 64B/66B coded signal.

It can be understood that this step is executed at the transmit end, and for the 1$^{st}$ 64B/66B code block after the T code block, the term "after" is relative to a sending direction. Assuming that a T code block is currently being sent, according to a sending order, a 64B/66B code block having already been sent corresponds to "before", and a 64B/66B code block to be sent corresponds to "after".

It can be understood that the check data area corresponding to the check information determined in this step should correspond to one MAC frame, and the check is performed for 64B/66B code blocks, i.e., the check range includes every bit of a plurality of 64B/66B code blocks. The check data area corresponding to the check information determined in this step is similar to that in step S102. Assuming that the 64B/66B code block currently being sent is a T code block, every 64B/66B code block is searched forward in sequence starting from the T code block until the 1st S code block is found. Assuming that the S code block is the Nth code block before the T code block, the starting position of the check data area corresponding to the check information is an (N-1)th 64B/66B code block before the T code block, and the ending position of the check data area is first 10 bits of the 1st 64B/66B code block after the T code block. The check data area includes N*66+10 bits, i.e., N 64B/66B code blocks plus 10 bits.

It can be understood that the check information of 24 bits needs to be generated in this step, and a specific method of generating the check information of 24 bits is as follows.

The check data area corresponding to the check information determined in this step includes 66*N+10 bits in total, and the 66*N+10 bits are grouped according to continuous 24 bits, i.e., the first 24 bits are grouped into a 1st group, 25th to 48th bits are grouped into a 2nd group, 49th to 72nd bits are grouped into a 3rd group, and so on, thus obtaining INT((66*N+10)/24) data groups, where INT(A) represents rounding down a decimal A, with a remainder being mod(66*N+10, 24), where mod(B, C) represents the remainder after B is divided by C, where B and C are both integers. If mod(66*N+10, 24) is equal to 0, INT((66*N+10)/24) data groups are finally obtained. If mod(66*N+10, 24) is not equal to 0, 24-mod(66*N+10, 24) bits of 0 are added to finally obtain INT((66*N+10)/24)+1 data groups. As such, an integer number of data groups are finally obtained, where each data group corresponds to 24 bits.

It can be understood that for the above integer number of data groups each corresponding to 24 bits, a BIP-24 algorithm can be used to generate check information of 24 bits. A specific implementation of the BIP-24 algorithm is to perform an XOR operation on the integer number of data groups, i.e., the first data group XOR the second data group XOR the third data group ... XOR the last data group, and using the result of the XOR operation as the check information of 24 bits.

It can be understood that for the above integer number of data groups each corresponding to 24 bits, a CRC-24 algorithm may also be used to generate check information of 24 bits. A generator polynomial of the CRC-24 algorithm may be:

$$G(x)=x^{24}+x^{23}+x^6+x^5+x+1.$$

A specific manner of generating check information using the CRC-24 algorithm is as follows.

Assuming that data to be checked includes K*24 bits, K being an integer greater than 1, w=K*24 is set, a polynomial M(x) of order w-1 is generated according to w bits, and w bits are used as coefficients of the polynomial M(x), where a 1st bit of the w bits is used as a coefficient of $x^{w-1}$, a 2nd bit of the w bits is used as a coefficient of $x^{w-2}$, a 3rd bit of the w bits is used as a coefficient of $x^{w-3}$, ..., and a wth bit of the w bits is used as a coefficient of $x^0$. The polynomial M(x) is multiplied by $x^{32}$ and then divided by a generator polynomial G(x) according to modulo 2 division to obtain a remainder polynomial R(x), where a maximum coefficient of the remainder polynomial is less than or equal to 23. A 24-bit value is obtained as the check information of 24 bits according to the coefficients of the remainder polynomial R(x).

At S303, the check information is written into a 1st 64B/66B code block after the T code block.

It can be understood that if the 1st 64B/66B code block after the T code block is the C-I code block, replacing the 1st 64B/66B code block after the T code block with a third preset code block;

if the 1st 64B/66B code block after the T code block is not the C-I code block, adding one third preset code block after the T code block, and incrementing a second addition counter by 1, where the second addition counter records a number of third preset code blocks added, and an initial value of the second addition counter is 0;

after the processing, the 1st 64B/66B code block after the T code block is the third preset code block; and writing the check information into the third preset code block.

When the C-I code block is found and a 1st 64B/66B code block before the found C-I code block is not the T code block, it is checked whether the second addition counter is 0; if the second addition counter is 0, no processing is performed; and if the second addition counter is not 0, the found C-I code block is deleted, and the second addition counter is decremented by 1.

The third preset code block is a check C-O code block, the check C-O code block is the C-O code block, the type of the ordered set control information in a 56-bit information field of the check C-O code block is a first preset value, and the first preset value is 4-bit information for distinguishing types of other ordered set control information already defined.

The content of the ordered set control information in the 56-bit information field of the check C-O code block is used for storing the check information of 24 bits.

Writing the check information of 24 bits into the content of the ordered set control information in the 56-bit information field of the check C-O code block.

It can be understood that in the C-O code block, the type of the ordered set control information occupies 4 bits, so there are at most 16 types of ordered set control information. At present, IEEE 802.3 has only defined two ordered set control types: sequence ordered sets and signal ordered sets. A new control type is defined and named check ordered sets. A specific 4-bit value is assigned to label the check ordered set, and a 64B/66B code block corresponding to the check ordered set is named check C-O code block. Since the C-O code block also includes the content of the ordered set control information which is 24 bits, check information of 24 bits may be defined in the check C-O code block.

It should be noted that when the T code block is followed by two exactly identical C-O code blocks, i.e., two C-O code blocks having the same content in the 56-bit information field, one of the C-O code blocks may be deleted according to Ethernet standards, or the 1st C-O code block after the T code block may be replaced with the third preset code block.

It can be understood that in the above processing, in some cases, one third preset code block needs to be added after the T code block, resulting in an additional 64B/66B code block. In such cases, it is necessary to use the second addition counter to record this addition operation, and subsequently delete one C-I code block once an appropriate C-I code block is found, to ensure that the total number of 64B/66B code blocks remains unchanged.

At S304, the 64B/66B coded signal is sent.

It can be understood that the sending of the 64B/66B coded signal may be implemented in a variety of manners, including at least the following manners:

sending the 64B/66B coded signal over a physical medium; or

encapsulating the 64B/66B coded signal into a service signal and sending the service signal; or

converting the 64B/66B coded signal into a coded signal of another format, and sending the coded signal of the another format.

Steps S307 to S309 are executed at the receive end.

At S307, the 64B/66B coded signal sent by the transmit end is received.

It can be understood that the 64B/66B coded signal received in this step is the 64B/66B coded signal sent in step S304. Corresponding to the variety of methods of sending the 64B/66B coded signal in step S304, this step includes a variety of implementation methods:

receiving, through a physical medium, the 64B/66B coded signal sent by the transmit end; or

receiving the service signal sent by the transmit end, and extracting the 64B/66B coded signal from the service signal; or

receiving the coded signal of the another format sent by the transmit end, and converting the coded signal of the another format into the 64B/66B coded signal.

At S308, the T code block is found and the check information is acquired according to the T code block.

It can be understood that finding the T code blocks includes finding every T code block in the 64B/66B coded signal received in step S307.

It can be understood that if it is detected that the 1st 64B/66B code block after the T code block is the check C-O code block, acquiring the check information of 24 bits from the content of the ordered set control information in the 56-bit information field of the check C-O code block.

It can be understood that this step is executed at the receive end, and for the 1st 64B/66B code block after the T code block, the term "after" is relative to a receiving direction. Assuming that a T code block is currently being received, according to a receiving order, a 64B/66B code block having already been received corresponds to "before", and a 64B/66B code block to be received corresponds to "after".

At S309, it is detected according to the check information whether a check error exists, and a subset of the 64B/66B code blocks is replaced depending on whether a check error exists.

It can be understood that detecting according to the check information whether a check error exists includes:

determining a check data area corresponding to the check information according to the T code block, where a length of the check data area is N*66+10 bits, N is an integer greater than 1, and last 10 bits of the check data area are first 10 bits of the 1st 64B/66B code block after the T code block; finding a 1st S code block before the T code block, where a 1st 64B/66B code block after the found 1st S code block before the T code block is a starting position of the check data area, and N 64B/66B code blocks are included from the starting position of the check data area to the T code block; and

regenerating 24-bit fifth check information according to a BIP-24 algorithm or a CRC-24 algorithm in the check data area corresponding to the check information, comparing the 24-bit fifth check information with the check information of 24 bits, determining that no check error exists if the 24-bit fifth check information is equal to the check information of 24 bits, and determining that a check error exists if the 24-bit fifth check information is not equal to the check information of 24 bits.

It can be understood that this step further includes:

if it is detected that the $1^{st}$ 64B/66B code block after the T code block is the check C-O code block and detected according to the check information in the check C-O code block that no check error exists, replacing the check C-O code block with the C-I code block;

if it is detected that the $1^{st}$ 64B/66B code block after the T code block is the check C-O code block and detected according to the check information in the check C-O code block that a check error exists, replacing a $P^{th}$ 64B/66B code block before the T code block with a 64B/66B code block representing error information, and replacing the check C-O code block with the C-I code block; and

if it is detected that the $1^{st}$ 64B/66B code block after the T code block is not the check C-O code block, replacing a $P^{th}$ 64B/66B code block before the T code block with a 64B/66B code block representing error information.

It can be understood that replacing a $P^{th}$ 64B/66B code block before the T code block with a 64B/66B code block representing error information includes the following four error replacement actions:

a first error replacement action: where P is 0, i.e., the T code block is replaced with the 64B/66B code block representing the error information, where the 64B/66B code block representing the error information has a synchronization header of 10, a type field of 0x1e, an information field including 8 error control characters, and the error control character is 7 bits of 0x1e;

a second error replacement action: where P is 0, i.e., the T code block is replaced with the 64B/66B code block representing the error information, where the 64B/66B code block representing the error information has a synchronization header of 00 or 11 and a block payload of 64 bits of 0;

a third error replacement action: where P is 1, i.e., the $1^{st}$ 64B/66B code block before the T code block is replaced with the 64B/66B code block representing the error information, where the 64B/66B code block representing the error information has a synchronization header of 10, a type field of Oxle, an information field including 8 error control characters, and the error control character is 7 bits of 0x1e; and

a fourth error replacement action: where P is 1, i.e., the $1^{st}$ 64B/66B code block before the T code block is replaced with the 64B/66B code block representing the error information, where the 64B/66B code block representing the error information has a synchronization header of 00 or 11 and a block payload of 64 bits of 0.

It can be understood that the check data area corresponding to the check information determined in this step is similar to that in step S109. Assuming that the 64B/66B code block currently being received is a T code block, every 64B/66B code block is searched forward in sequence starting from the T code block until the $1^{st}$ S code block is found. Assuming that the S code block is the $N^{th}$ code block before the T code block, the starting position of the check data area corresponding to the check information is an $(N-1)^{th}$ 64B/66B code block before the T code block, and the ending position of the check data area is first 10 bits of the $1^{st}$ 64B/66B code block after the T code block. The check data area includes N*66+10 bits, i.e., N 64B/66B code blocks plus 10 bits.

It can be understood that when the second check information of 24 bits is regenerated according to the BIP-24 algorithm or the CRC-24 algorithm, a specific implementation of the BIP-24 algorithm or the CRC-24 algorithm is as described in step S102. The length of the check data area corresponding to the check information is N*66+10 bits. First, a maximum of 23 bits of 0 is added after the N*66+10 bits to extend the length to 24*K bits, where K is an integer greater than 1. Then, the fifth check information of 24 bits is generated for the 24*K bits according to the BIP-24 algorithm or the CRC-24 algorithm in step S102. The fifth check information of 24 bits is compared with the 24-bit check information in the 56-bit information field of the check C-O code block. If the fifth check information is equal to the 24-bit check information, it is determined that no check error occurs. If the fifth check information is not equal to the 24-bit check information, it is determined that a check error occurs.

It can be understood that the effect of replacing the $P^{th}$ 64B/66B code block before the T code block with the 64B/66B code block representing the error information is to delete the end-of- frame flag of the MAC frame, so that the MAC frame with the error will be discarded in subsequent processing due to failing to find the end-of-frame flag of the MAC frame.

In another embodiment, a communication device is provided, including a sending module and a receiving module, where the sending module is used at a transmit end to execute the 64B/66B coded signal processing method of any of the above embodiments; and the receiving module is used at a receive end to execute the 64B/66B coded signal processing method of any of the above embodiments.

In another embodiment, an electronic device is provided, including: one or more processors; and a memory, storing one or more programs which, when executed by the one or more processors, cause the one or more processors to implement the 64B/66B coded signal processing method of any of the above embodiments.

In another embodiment, a computer-readable medium is provided, storing a computer program which, when executed by a processor, causes the processor to implement the 64B/66B coded signal processing method of any of the above embodiments.

Those having ordinary skills in the art can understand that all or some of the steps in the methods disclosed above and the functional modules/units in the system and the apparatus can be implemented as software, firmware, hardware, and appropriate combinations thereof. In a hardware implementation, the division of the functional modules/units mentioned in the above description does not necessarily correspond to the division of physical components. For example, one physical component may have multiple functions, or one function or step may be jointly executed by several physical components. Some or all physical components may be implemented as software executed by a processor, such as a central processing unit, a digital signal processor, or a microprocessor, or as hardware, or as an integrated circuit, such as an application-specific integrated circuit. Such software may be distributed on a computer-readable medium, which may include a computer storage medium (or non-transitory medium) and a communication medium (or transitory medium). As is known to those having ordinary skills in the art, the term "computer storage medium" includes volatile and nonvolatile, removable and non-removable media implemented in any method or technology for storage of information (such as computer readable instructions, data structures, program modules, or other data). The computer storage medium includes, but is not limited to, a random access memory (RAM), a read-only memory (ROM), an electrically erasable programmable read-only memory (EEPROM), a flash memory or other memory technology, a compact disc read-only memory (CD-ROM), a digital versatile disc (DVD) or other optical storage, a cassette, a magnetic tape, a magnetic disk storage or other magnetic storage device, or any other medium which can be used to store the desired information and which can be accessed by a computer. In addition, as is known to those having ordinary skills in the art, the communication medium typically includes computer-readable instructions, data structures, program modules, or other data in a modulated data signal such as a carrier or other transport mechanism, and can include any information passing medium.

The embodiments have been disclosed herein, and although specific terms are employed, they are used and should only be construed in a general descriptive sense and not for purposes of limitation. In some examples, it will be apparent to those having ordinary skills the art that unless expressly stated otherwise, a feature, characteristic, and/or element described in conjunction with a particular embodiment may be used alone or in combination with a feature, characteristic, and/or element described in conjunction with another embodiment. Therefore, it will be understood by those having ordinary skills in the art that various changes in form and details may be made without departing from the scope of the present disclosure as set forth in the appended claims.

**Claims**

1. A 64B/66B coded signal processing method, comprising:

   at a transmit end, acquiring a 64B/66B coded signal, wherein the 64B/66B coded signal is composed of 64B/66B code blocks, and the 64B/66B code blocks comprise at least one of an S code block, a T code block, a C code block, a D code block, or an E code block;
   finding the T code block and generating check information according to a preset scheme;
   writing the check information into a 1st 64B/66B code block after the T code block; and
   sending the 64B/66B coded signal; and
   at a receive end, receiving the 64B/66B coded signal sent by the transmit end;
   finding the T code block and acquiring the check information according to the T code block;
   detecting according to the check information whether a check error exists, and replacing a subset of the 64B/66B code blocks depending on whether a check error exists; and
   finally obtaining the 64B/66B coded signal, so that an error introduced in the sending process is labeled.

2. The method of claim 1, wherein the 64B/66B code blocks each comprise a 2-bit synchronization header and a 64-bit block payload, the block payload comprises an 8-bit type field and a 56-bit information field in response to the 2-bit synchronization header being 10, and the block payload comprises a 64-bit information field in response to the 2-bit synchronization header being 01;

a synchronization header of the S code block is 10, a type field of the S code block comprises a start-of-frame flag, and the start-of-frame flag is 0x78;

a synchronization header of the T code block is 10, a type field of the T code block comprises an end-of-frame flag, and the end-of-frame flag is one of 0x87, 0x99, 0xaa, 0xb4, 0xcc, 0xd2, 0xe1 or 0xff;

the C code block comprises a C-I code block and a C-O code block, wherein a synchronization header of the C-I code block is 10, a type field of the C-I code block is 0x1e, an information field of the C-I code block comprises 8 idle control characters, and the idle control character is 7 bits of 0; a synchronization header of the C-O code block is 10, a type field of the C-O code block is 0x4b, first 28 bits of an information field of the C-O code block comprise a content and a type of ordered set control information, and last 28 bits of the information field are fixed to 0x000_0000;

a synchronization header of the D code block is 01; and

the E code block is the 64B/66B code block other than the S code block, the T code block, the C code block, and the D code block.

3. The method of claim 2, wherein finding the T code block and generating check information according to a preset scheme comprises:

determining a check data area corresponding to the check information according to the T code block, wherein a length of the check data area is N*66+10 bits, N is an integer greater than 1, and last 10 bits of the check data area are first 10 bits of the $1^{st}$ 64B/66B code block after the T code block; finding a $1^{st}$ S code block before the T code block, wherein a $1^{st}$ 64B/66B code block after the found $1^{st}$ S code block before the T code block is a starting position of the check data area, and N 64B/66B code blocks are comprised from the starting position of the check data area to the T code block; and

generating the check information according to a preset check method in the check data area.

4. The method of claim 3, wherein generating the check information according to a preset check method in the check data area comprises:

generating the check information of 24 bits in the check data area according to a BIP-24 algorithm or a CRC-24 algorithm; or generating the check information of 32 bits in the check data area according to a BIP-32 algorithm or a CRC-32 algorithm.

5. The method of claim 4, wherein writing the check information into a $1^{st}$ 64B/66B code block after the T code block comprises:

in response to the $1^{st}$ 64B/66B code block after the T code block being the S code block, keeping the $1^{st}$ 64B/66B code block after the T code block unchanged;

in response to the $1^{st}$ 64B/66B code block after the T code block being the C-I code block, replacing the $1^{st}$ 64B/66B code block after the T code block with a first preset code block;

in response to the $1^{st}$ 64B/66B code block after the T code block being neither the S code block nor the C-I code block, adding one first preset code block after the T code block, and incrementing a first addition counter by 1, wherein the first addition counter records a number of first preset code blocks added, and an initial value of the first addition counter is 0;

after the processing, the $1^{st}$ 64B/66B code block after the T code block is the S code block or the first preset code block; and writing the check information into the S code block or the first preset code block.

6. The method of claim 5, wherein in response to the C-I code block being found and a $1^{st}$ 64B/66B code block before the found C-I code block being not the T code block, it is checked whether the first addition counter is 0; in response to the first addition counter being 0, no processing is performed; and in response to the first addition counter being not 0, the found C-I code block is deleted, and the first addition counter is decremented by 1.

7. The method of claim 6, wherein:

the first preset code block is a check C-O code block or the D code block, wherein the check C-O code block is the C-O code block, the type of the ordered set control information in a 56-bit information field of the check C-O code block is a first preset value, and the first preset value is 4-bit information for distinguishing types of other ordered set control information already defined;

in response to the first preset code block being the check C-O code block, the content of the ordered set control information in the 56-bit information field of check C-O code block is used for storing the check information of 24 bits, and writing the check information into the S code block or the first preset code block comprises writing the check information of 24 bits into the content of the ordered set control information in the 56-bit information field of the check C-O code block or writing the check information of 24 bits into 1st to 24th bits of a 56-bit information field of the S code block; and

in response to the first preset code block being the D code block, 1st to 32nd bits of the block payload of the D code block are used for storing the check information, 33rd to 64th bits of the block payload are fixed to 0, and writing the check information into the S code block or the first preset code block comprises writing the check information of 32 bits into the 1st to 32nd bits of the block payload of the D code block or writing the check information of 32 bits into 1st to 32nd bits of a 56-bit information field of the S code block.

8. The method of claim 7, wherein sending the 64B/66B coded signal comprises:

sending the 64B/66B coded signal over a physical medium; or

encapsulating the 64B/66B coded signal into a service signal and sending the service signal; or

converting the 64B/66B coded signal into a coded signal of another format, and sending the coded signal of the another format.

9. The method of claim 8, wherein at a receive end, receiving the 64B/66B coded signal sent by the transmit end comprises:

at the receive end, receiving, through a physical medium, the 64B/66B coded signal sent by the transmit end; or

at the receive end, receiving the service signal sent by the transmit end, and extracting the 64B/66B coded signal from the service signal; or

at the receive end, receiving the coded signal of the another format sent by the transmit end, and converting the coded signal of the another format into the 64B/66B coded signal.

10. The method of claim 9, wherein finding the T code block and acquiring the check information according to the T code block comprises:

in response to the first preset code block being the check C-O code block:

in response to detecting that the 1st 64B/66B code block after the T code block is the check C-O code block, acquiring the check information of 24 bits from the content of the ordered set control information in the 56-bit information field of the check C-O code block; and

in response to detecting that the 1st 64B/66B code block after the T code block is the S code block, acquiring the check information of 24 bits from the 1st to 24th bits of the 56-bit information field of the S code block; and in response to the first preset code block being the D code block:

in response to detecting that the 1st 64B/66B code block after the T code block is the D code block, acquiring the check information of 32 bits from the 1st to 32nd bits of the block payload of the D code block; and

in response to detecting that the 1st 64B/66B code block after the T code block is the S code block, acquiring the check information of 32 bits from the 1st to 32nd bits of the 56-bit information field of the S code block.

11. The method of claim 10, wherein detecting according to the check information whether a check error exists comprises:

determining a check data area corresponding to the check information according to the T code block, wherein a length of the check data area is N*66+10 bits, N is an integer greater than 1, and last 10 bits of the check data area are first 10 bits of the 1st 64B/66B code block after the T code block; finding a 1st S code block before the T code block, wherein a 1st 64B/66B code block after the found 1st S code block before the T code block is a starting position of the check data area, and N 64B/66B code blocks are comprised from the starting position of the check data area to the T code block;

in response to the first preset code block being the check C-O code block, regenerating 24-bit second check information according to a BIP-24 algorithm or a CRC-24 algorithm in the check data area corresponding to the check information, comparing the 24-bit second check information with the check information of 24 bits, determining that no check error exists in response to the 24-bit second check information being equal to the check information of 24 bits, and determining that a check error exists in response to the 24-bit second check information being not equal to the check information of 24 bits; and

in response to the first preset code block being the D code block, regenerating 32-bit third check information according to a BIP-32 algorithm or a CRC-32 algorithm in the check data area corresponding to the check information, comparing the 32-bit third check information with the check information of 32 bits, determining that no check error exists in response to the 32-bit third check information being equal to the check information of 32 bits, and determining that a check error exists in response to the 32-bit third check information being not equal to the check information of 32 bits.

**12.** The method of claim 11, wherein detecting according to the check information whether a check error exists, and replacing a subset of the 64B/66B code blocks depending on whether a check error exists comprises:
in response to the first preset code block being the check C-O code block:

in response to detecting that the 1st 64B/66B code block after the T code block is the S code block and detecting according to the check information in the S code block that no check error exists, writing 7 bytes of 0xaa into the 56-bit information field of the S code block;
in response to detecting that the 1st 64B/66B code block after the T code block is the S code block and detecting according to the check information in the S code block that a check error exists, replacing a $P^{th}$ 64B/66B code block before the T code block with a 64B/66B code block representing error information, and writing 7 bytes of 0xaa into the 56-bit information field of the S code block, wherein P is an integer greater than or equal to 0;
in response to detecting that the 1st 64B/66B code block after the T code block is the check C-O code block and detecting according to the check information in the check C-O code block that no check error exists, replacing the check C-O code block with the C-I code block;
in response to detecting that the 1st 64B/66B code block after the T code block is the check C-O code block and detecting according to the check information in the check C-O code block that a check error exists, replacing a $P^{th}$ 64B/66B code block before the T code block with a 64B/66B code block representing error information, and replacing the check C-O code block with the C-I code block; and
in response to detecting that the 1st 64B/66B code block after the T code block is neither the S code block nor the check C-O code block, replacing a $P^{th}$ 64B/66B code block before the T code block with a 64B/66B code block representing error information; and

in response to the first preset code block being the D code block:

in response to detecting that the 1st 64B/66B code block after the T code block is the S code block and detecting according to the check information in the S code block that no check error exists, writing 7 bytes of 0xaa into the 56-bit information field of the S code block;
in response to detecting that the 1st 64B/66B code block after the T code block is the S code block and detecting according to the check information in the S code block that a check error exists, replacing a $P^{th}$ 64B/66B code block before the T code block with a 64B/66B code block representing error information, and writing 7 bytes of 0xaa into the 56-bit information field of the S code block, wherein P is an integer greater than or equal to 0;
in response to detecting that the 1st 64B/66B code block after the T code block is the D code block and detecting according to the check information in the D code block that no check error exists, replacing the D code block with the C-I code block;
in response to detecting that the 1st 64B/66B code block after the T code block is the D code block and detecting according to the check information in the D code block that a check error exists, replacing a $P^{th}$ 64B/66B code block before the T code block with a 64B/66B code block representing error information, and replacing the D code block with the C-I code block; and
in response to detecting that the 1st 64B/66B code block after the T code block is neither the S code block nor the D code block, replacing a $P^{th}$ 64B/66B code block before the T code block with a 64B/66B code block representing error information.

**13.** The method of claim 12, wherein replacing a $P^{th}$ 64B/66B code block before the T code block with a 64B/66B code block representing error information comprises the following four error replacement actions:

a first error replacement action: wherein P is 0, i.e., the T code block is replaced with the 64B/66B code block representing the error information, wherein the 64B/66B code block representing the error information has a synchronization header of 10, a type field of Oxle, an information field comprising 8 error control characters, and the error control character is 7 bits of 0x1e;
a second error replacement action: wherein P is 0, i.e., the T code block is replaced with the 64B/66B code block representing the error information, wherein the 64B/66B code block representing the error information has a synchronization header of 00 or 11 and a block payload of 64 bits of 0;

a third error replacement action: wherein P is 1, i.e., the 1st 64B/66B code block before the T code block is replaced with the 64B/66B code block representing the error information, wherein the 64B/66B code block representing the error information has a synchronization header of 10, a type field of Oxle, an information field comprising 8 error control characters, and the error control character is 7 bits of 0x1e; and

a fourth error replacement action: wherein P is 1, i.e., the 1st 64B/66B code block before the T code block is replaced with the 64B/66B code block representing the error information, wherein the 64B/66B code block representing the error information has a synchronization header of 00 or 11 and a block payload of 64 bits of 0.

14. The method of claim 4, wherein writing the check information into a 1st 64B/66B code block after the T code block comprises:

in response to the 1st 64B/66B code block after the T code block being the S code block, keeping the 1st 64B/66B code block after the T code block unchanged;

in response to the 1st 64B/66B code block after the T code block being not the S code block, replacing the 1st 64B/66B code block after the T code block with a second preset code block, and writing partial information of the 1st 64B/66B code block after the T code block into the second preset code block;

after the processing, the 1st 64B/66B code block after the T code block is the S code block or the second preset code block; and writing the check information into the S code block or the second preset code block.

15. The method of claim 14, wherein in response to the 1st 64B/66B code block after the T code block being not the S code block, replacing the 1st 64B/66B code block after the T code block with a second preset code block, and writing partial information of the 1st 64B/66B code block after the T code block into the second preset code block comprises:

the second preset code block is the D code block, 1st to 32nd bits of the block payload of the D code block are used for storing the check information, 33rd to 36th bits of the block payload are used for storing a coding type of the replaced 64B/66B code block, and 37th to 64th bits of the block payload are used for storing partial information of the replaced 64B/66B code block,

in response to the 1st 64B/66B code block after the T code block being the C-I code block, simultaneously writing a value of 1 into the 33rd to 36th bits of the block payload in the D code block;

in response to the 1st 64B/66B code block after the T code block being the C-O code block, simultaneously writing a value of 2 into the 33rd to 36th bits of the block payload in the D code block, and simultaneously writing 1st to 28th bits of the information field of the C-O code block into the 37th to 64th bits of the block payload in the D code block; and

in response to the 1st 64B/66B code block after the T code block being one of the T code block, the D code block, or the E code block, simultaneously writing a value of 3 into the 33rd to 36th bits of the block payload in the D code block.

16. The method of claim 15, wherein writing the check information into the S code block or the second preset code block comprises writing the check information of 32 bits into the 1st to 32nd bits of the block payload of the D code block or writing the check information of 32 bits into 1st to 32nd bits of a 56-bit information field of the S code block.

17. The method of claim 16, wherein sending the 64B/66B coded signal comprises:

sending the 64B/66B coded signal over a physical medium; or
encapsulating the 64B/66B coded signal into a service signal and sending the service signal; or
converting the 64B/66B coded signal into a coded signal of another format, and sending the coded signal of the another format.

18. The method of claim 17, wherein at a receive end, receiving the 64B/66B coded signal sent by the transmit end comprises:

at the receive end, receiving, through a physical medium, the 64B/66B coded signal sent by the transmit end; or
at the receive end, receiving the service signal sent by the transmit end, and extracting the 64B/66B coded signal from the service signal; or
at the receive end, receiving the coded signal of the another format sent by the transmit end, and converting the coded signal of the another format into the 64B/66B coded signal.

19. The method of claim 18, wherein finding the T code block and acquiring the check information according to the T code block comprises:

in response to detecting that the 1st 64B/66B code block after the T code block is the D code block, acquiring the check information of 32 bits from the 1st to 32nd bits of the block payload of the D code block; and
in response to detecting that the 1st 64B/66B code block after the T code block is the S code block, acquiring the check information of 32 bits from the 1st to 32nd bits of the 56-bit information field of the S code block.

20. The method of claim 19, wherein detecting according to the check information whether a check error exists comprises:

determining a check data area corresponding to the check information according to the T code block, wherein a length of the check data area is N*66+10 bits, N is an integer greater than 1, and last 10 bits of the check data area are first 10 bits of the 1st 64B/66B code block after the T code block; finding a 1st S code block before the T code block, wherein a 1st 64B/66B code block after the found 1st S code block before the T code block is a starting position of the check data area, and N 64B/66B code blocks are comprised from the starting position of the check data area to the T code block; and
regenerating 32-bit fourth check information according to a BIP-32 algorithm or a CRC-32 algorithm in the check data area corresponding to the check information, comparing the 32-bit fourth check information with the check information of 32 bits, determining that no check error exists in response to the 32-bit fourth check information being equal to the check information of 32 bits, and determining that a check error exists in response to the 32-bit fourth check information being not equal to the check information of 32 bits.

21. The method of claim 20, wherein detecting according to the check information whether a check error exists, and replacing a subset of the 64B/66B code blocks depending on whether a check error exists comprises:

in response to detecting that the 1st 64B/66B code block after the T code block is the S code block and detecting according to the check information in the S code block that no check error exists, writing 7 bytes of 0xaa into the 56-bit information field of the S code block;
in response to detecting that the 1st 64B/66B code block after the T code block is the S code block and detecting according to the check information in the S code block that a check error exists, replacing a Pth 64B/66B code block before the T code block with a 64B/66B code block representing error information, and writing 7 bytes of 0xaa into the 56-bit information field of the S code block, wherein P is an integer greater than or equal to 0;
in response to detecting that the 1st 64B/66B code block after the T code block is the D code block and detecting according to the check information in the D code block that no check error exists, detecting the 33rd to 36th bits of the block payload of the D code block; in response to the 33rd to 36th bits being a value of 1, replacing the D code block with the C-I code block; in response to the 33rd to 36th bits being a value of 2, replacing the D code block with the C-O code block, and writing the 37th to 64th bits of the block payload of the D code block into the 1st to 28th bits of the information field of the C-O code block; in response to the 33rd to 36th bits being neither a value of 1 nor a value of 2, replacing the D code block with a 64B/66B code block comprising 8 error control characters, wherein the 64B/66B code block comprising the 8 error control characters has a synchronization header of 10, a type field of 0x1e, and an information field comprising the 8 error control characters, and the error control character is 7 bits of 0x1e;
in response to detecting that the 1st 64B/66B code block after the T code block is the D code block and detecting according to the check information in the D code block that a check error exists, replacing a Pth 64B/66B code block before the T code block with a 64B/66B code block representing error information, and detecting the 33rd to 36th bits of the block payload of the D code block; in response to the 33rd to 36th bits being a value of 1, replacing the D code block with the C-I code block; in response to the 33rd to 36th bits being a value of 2, replacing the D code block with the C-O code block, and writing the 37th to 64th bits of the block payload of the D code block into the 1st to 28th bits of the information field of the C-O code block; in response to the 33rd to 36th bits being neither a value of 1 nor a value of 2, replacing the D code block with a 64B/66B code block comprising 8 error control characters, wherein the 64B/66B code block comprising the 8 error control characters has a synchronization header of 10, a type field of 0x1e, and an information field comprising the 8 error control characters, and the error control character is 7 bits of 0x1e; and
in response to detecting that the 1st 64B/66B code block after the T code block is neither the S code block nor the D code block, replacing a Pth 64B/66B code block before the T code block with a 64B/66B code block representing error information.

22. The method of claim 21, wherein replacing a Pth 64B/66B code block before the T code block with a 64B/66B code block representing error information comprises the following four error replacement actions:

a first error replacement action: wherein P is 0, i.e., the T code block is replaced with the 64B/66B code block representing the error information, wherein the 64B/66B code block representing the error information has a synchronization header of 10, a type field of Oxle, an information field comprising 8 error control characters, and the error control character is 7 bits of 0x1e; and

a second error replacement action: wherein P is 0, i.e., the T code block is replaced with the 64B/66B code block representing the error information, wherein the 64B/66B code block representing the error information has a synchronization header of 00 or 11 and a block payload of 64 bits of 0;

a third error replacement action: wherein P is 1, i.e., the $1^{st}$ 64B/66B code block before the T code block is replaced with the 64B/66B code block representing the error information, wherein the 64B/66B code block representing the error information has a synchronization header of 10, a type field of Oxle, an information field comprising 8 error control characters, and the error control character is 7 bits of 0x1e; and

a fourth error replacement action: wherein P is 1, i.e., the $1^{st}$ 64B/66B code block before the T code block is replaced with the 64B/66B code block representing the error information, wherein the 64B/66B code block representing the error information has a synchronization header of 00 or 11 and a block payload of 64 bits of 0.

23. The method of claim 4, writing the check information into a $1^{st}$ 64B/66B code block after the T code block comprises:

in response to the $1^{st}$ 64B/66B code block after the T code block being the C-I code block, replacing the $1^{st}$ 64B/66B code block after the T code block with a third preset code block;

in response to the $1^{st}$ 64B/66B code block after the T code block being not the C-I code block, adding one third preset code block after the T code block, and incrementing a second addition counter by 1, wherein the second addition counter records a number of third preset code blocks added, and an initial value of the second addition counter is 0;

after the processing, the $1^{st}$ 64B/66B code block after the T code block is the third preset code block; and writing the check information into the third preset code block.

24. The method of claim 23, wherein in response to the C-I code block being found and a $1^{st}$ 64B/66B code block before the found C-I code block being not the T code block, it is checked whether the second addition counter is 0; in response to the second addition counter being 0, no processing is performed; and in response to the second addition counter being not 0, the found C-I code block is deleted, and the second addition counter is decremented by 1.

25. The method of claim 24, wherein:

the third preset code block is a check C-O code block, the check C-O code block is the C-O code block, the type of the ordered set control information in a 56-bit information field of the check C-O code block is a first preset value, and the first preset value is 4-bit information for distinguishing types of other ordered set control information already defined;

the content of the ordered set control information in the 56-bit information field of the check C-O code block is used for storing the check information of 24 bits, and writing the check information into the third preset code block comprises writing the check information of 24 bits into the content of the ordered set control information in the 56-bit information field of the check C-O code block.

26. The method of claim 25, wherein sending the 64B/66B coded signal comprises:

sending the 64B/66B coded signal over a physical medium; or

encapsulating the 64B/66B coded signal into a service signal and sending the service signal; or

converting the 64B/66B coded signal into a coded signal of another format, and sending the coded signal of the another format.

27. The method of claim 26, wherein at a receive end, receiving the 64B/66B coded signal sent by the transmit end comprises:

at the receive end, receiving, through a physical medium, the 64B/66B coded signal sent by the transmit end; or

at the receive end, receiving the service signal sent by the transmit end, and extracting the 64B/66B coded signal from the service signal; or

at the receive end, receiving the coded signal of the another format sent by the transmit end, and converting the coded signal of the another format into the 64B/66B coded signal.

28. The method of claim 27, wherein finding the T code block and acquiring the check information according to the T code block comprises:

in response to detecting that the 1st 64B/66B code block after the T code block is the check C-O code block, acquiring the check information of 24 bits from the content of the ordered set control information in the 56-bit information field of the check C-O code block.

29. The method of claim 28, wherein detecting according to the check information whether a check error exists comprises:

determining a check data area corresponding to the check information according to the T code block, wherein a length of the check data area is N*66+10 bits, N is an integer greater than 1, and last 10 bits of the check data area are first 10 bits of the 1st 64B/66B code block after the T code block; finding a 1st S code block before the T code block, wherein a 1st 64B/66B code block after the found 1st S code block before the T code block is a starting position of the check data area, and N 64B/66B code blocks are comprised from the starting position of the check data area to the T code block; and

regenerating 24-bit fifth check information according to a BIP-24 algorithm or a CRC-24 algorithm in the check data area corresponding to the check information, comparing the 24-bit fifth check information with the check information of 24 bits, determining that no check error exists in response to the 24-bit fifth check information being equal to the check information of 24 bits, and determining that a check error exists in response to the 24-bit fifth check information being not equal to the check information of 24 bits.

30. The method of claim 29, wherein detecting according to the check information whether a check error exists, and replacing a subset of the 64B/66B code blocks depending on whether a check error exists comprises:

in response to detecting that the 1st 64B/66B code block after the T code block is the check C-O code block and detecting according to the check information in the check C-O code block that no check error exists, replacing the check C-O code block with the C-I code block;

in response to detecting that the 1st 64B/66B code block after the T code block is the check C-O code block and detecting according to the check information in the check C-O code block that a check error exists, replacing a Pth 64B/66B code block before the T code block with a 64B/66B code block representing error information, and replacing the check C-O code block with the C-I code block; and

in response to detecting that the 1st 64B/66B code block after the T code block is not the check C-O code block, replacing a Pth 64B/66B code block before the T code block with a 64B/66B code block representing error information.

31. The method of claim 30, wherein replacing a Pth 64B/66B code block before the T code block with a 64B/66B code block representing error information comprises the following four error replacement actions:

a first error replacement action: wherein P is 0, i.e., the T code block is replaced with the 64B/66B code block representing the error information, wherein the 64B/66B code block representing the error information has a synchronization header of 10, a type field of 0x1e, an information field comprising 8 error control characters, and the error control character is 7 bits of 0x1e; and

a second error replacement action: wherein P is 0, i.e., the T code block is replaced with the 64B/66B code block representing the error information, wherein the 64B/66B code block representing the error information has a synchronization header of 00 or 11 and a block payload of 64 bits of 0;

a third error replacement action: wherein P is 1, i.e., the 1st 64B/66B code block before the T code block is replaced with the 64B/66B code block representing the error information, wherein the 64B/66B code block representing the error information has a synchronization header of 10, a type field of 0x1e, an information field comprising 8 error control characters, and the error control character is 7 bits of 0x1e; and

a fourth error replacement action: wherein P is 1, i.e., the 1st 64B/66B code block before the T code block is replaced with the 64B/66B code block representing the error information, wherein the 64B/66B code block representing the error information has a synchronization header of 00 or 11 and a block payload of 64 bits of 0.

32. A communication device, comprising a sending module and a receiving module, wherein

the sending module is used at a transmit end to execute the 64B/66B coded signal processing method of any of claims 1 to 31; and

the receiving module is used at a receive end to execute the 64B/66B coded signal processing method of any of claims 1 to 31.

33. An electronic device, comprising:

one or more processors; and
a memory, storing one or more programs which, when executed by the one or more processors, cause the one or more processors to perform the 64B/66B coded signal processing method of any of claims 1 to 31.

34. A computer-readable medium, storing a computer program which, when executed by a processor, causes the processor to perform the 64B/66B coded signal processing method of any of claims 1 to 31.

| Input Data | Sync | Block Payload | | | | | | | | |
|---|---|---|---|---|---|---|---|---|---|---|
| **Bit Position:**  Data Block Format: | 0 1 | 2 | | | | | | | | 65 |
| $D_0 D_1 D_2 D_3 D_4 D_5 D_6 D_7$ | 01 | $D_0$ | $D_1$ | $D_2$ | $D_3$ | $D_4$ | $D_5$ | $D_6$ | $D_7$ | |
| **Control Block Formats:** | | **Block Type Field** | | | | | | | | |
| $C_0 C_1 C_2 C_3 C_4 C_5 C_6 C_7$ | 10 | 0x1E | $C_0$ | $C_1$ | $C_2$ | $C_3$ | $C_4$ | $C_5$ | $C_6$ | $C_7$ |
| $S_0 D_1 D_2 D_3 D_4 D_5 D_6 D_7$ | 10 | 0x78 | | $D_1$ | $D_2$ | $D_3$ | $D_4$ | $D_5$ | $D_6$ | $D_7$ |
| $O_0 D_1 D_2 D_3 Z_4 Z_5 Z_6 Z_7$ | 10 | 0x4B | | $D_1$ | $D_2$ | $D_3$ | $O_0$ | 0x000_0000 | | |
| $T_0 C_1 C_2 C_3 C_4 C_5 C_6 C_7$ | 10 | 0x87 | | (hatched) | $C_1$ | $C_2$ | $C_3$ | $C_4$ | $C_5$ | $C_6$ | $C_7$ |
| $D_0 T_1 C_2 C_3 C_4 C_5 C_6 C_7$ | 10 | 0x99 | $D_0$ | (hatched) | $C_2$ | $C_3$ | $C_4$ | $C_5$ | $C_6$ | $C_7$ |
| $D_0 D_1 T_2 C_3 C_4 C_5 C_6 C_7$ | 10 | 0xAA | $D_0$ | $D_1$ | (hatched) | $C_3$ | $C_4$ | $C_5$ | $C_6$ | $C_7$ |
| $D_0 D_1 D_2 T_3 C_4 C_5 C_6 C_7$ | 10 | 0xB4 | $D_0$ | $D_1$ | $D_2$ | (hatched) | $C_4$ | $C_5$ | $C_6$ | $C_7$ |
| $D_0 D_1 D_2 D_3 T_4 C_5 C_6 C_7$ | 10 | 0xCC | $D_0$ | $D_1$ | $D_2$ | $D_3$ | (hatched) | $C_5$ | $C_6$ | $C_7$ |
| $D_0 D_1 D_2 D_3 D_4 T_5 C_6 C_7$ | 10 | 0xD2 | $D_0$ | $D_1$ | $D_2$ | $D_3$ | $D_4$ | (hatched) | $C_6$ | $C_7$ |
| $D_0 D_1 D_2 D_3 D_4 D_5 T_6 C_7$ | 10 | 0xE1 | $D_0$ | $D_1$ | $D_2$ | $D_3$ | $D_4$ | $D_5$ | (hatched) | $C_7$ |
| $D_0 D_1 D_2 D_3 D_4 D_5 D_6 T_7$ | 10 | 0xFF | $D_0$ | $D_1$ | $D_2$ | $D_3$ | $D_4$ | $D_5$ | $D_6$ | (hatched) |

FIG. 1

| | | |
|---|---|---|
| 7 bytes | Preamble | |
| 1 byte | Start-of-frame flag | |
| 6 bytes | Destination address | |
| 6 bytes | Source address | |
| 2 bytes | Type or length | MAC frame |
| 46 to 1500 bytes | MAC frame content | |
| 4 bytes | FCS-32 | |
| 1 byte | End-of-frame flag | |

Check area corresponding to FCS-32

FIG. 2

Transmit end

Acquire a 64B/66B coded signal, where the 64B/66B coded signal is composed of 64B/66B code blocks — S1

Find the T code block and generate check information according to a preset scheme — S2

Write the check information into a 1st 64B/66B code block after the T code block — S3

Send the 64B/66B coded signal — S4

Receive end

Receive the 64B/66B coded signal sent by the transmit end — S7

Find the T code block and acquire the check information according to the T code block — S8

Detect according to the check information whether a check error exists, and replace a subset of the 64B/66B code blocks depending on whether a check error exists — S9

FIG. 3

Code block
being sent

Code block having already
been sent (1st code block
before the current code block )

Next code block to be sent
(1st code block after the
current code block)

Sending direction

| D code block | T code block | S code block |

## FIG. 4

Code block having
already been sent ((N-
1)th code block before the
current code block)

Code block being
sent

Code block having
already been sent (Nth
code block before the
current code block)

Code block having
already been sent (1st
code block before the
current code block)

Next code block to
be sent (1st code
block after the
current code block)

Sending
direction

| S code block | D code block | ... | D code block | T code block | S code block |

Check data
area (N*66+10
bits)

## FIG. 5

Code block
being received

Code block having already
been received (1st code block
before the current code block)

Next code block to be
received (1st code block after
the current code block)

Receiving direction

| D code block | T code block | Check C-0 code block |

## FIG. 6

Code block having
already been received
((N-1)$^{th}$ code block before
the current code block)

Code block
being received

Code block having
already been received
(N$^{th}$ code block before
the current code block)

Code block having
already been received
(1$^{st}$ code block before
the current code block)

Next code block to be
received (1$^{st}$ code
block after the current
code block)

Receiving
direction

| S code block | D code block | ... | D code block | T code block | Check C-0 code block |

Check data area
(N*66+10 bits)

FIG. 7

## INTERNATIONAL SEARCH REPORT

| | International application No. |
| --- | --- |
| | **PCT/CN2023/129362** |

| A. | CLASSIFICATION OF SUBJECT MATTER |
| --- | --- |

H04L1/00(2006.01)i

According to International Patent Classification (IPC) or to both national classification and IPC

| B. | FIELDS SEARCHED |
| --- | --- |

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

CNTXT, ENTXTC, DWPI, CNKI, IEEE: 64B/66B, 帧, 编码块, 码块, 代码块, 结束, T块, 校验, frame, block, terminate, check, CRC, BIP, FCS

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2021254508 A1 (HUAWEI TECHNOLOGIES CO., LTD.) 23 December 2021 (2021-12-23) <br> description, page 7, line 15-page 9, line 2, and page 18, line 11-page 27, line 31 | 1-34 |
| A | CN 109698732 A (HUAWEI TECHNOLOGIES CO., LTD.) 30 April 2019 (2019-04-30) <br> entire document | 1-34 |
| A | CN 112104471 A (HUAWEI TECHNOLOGIES CO., LTD.) 18 December 2020 (2020-12-18) <br> entire document | 1-34 |
| A | WO 2021238791 A1 (HUAWEI TECHNOLOGIES CO., LTD.) 02 December 2021 (2021-12-02) <br> entire document | 1-34 |
| A | WO 2022022727 A1 (HUAWEI TECHNOLOGIES CO., LTD.) 03 February 2022 (2022-02-03) <br> entire document | 1-34 |
| A | WO 2022056884 A1 (HUAWEI TECHNOLOGIES CO., LTD.) 24 March 2022 (2022-03-24) <br> entire document | 1-34 |

☐ Further documents are listed in the continuation of Box C.  ☑ See patent family annex.

| | | |
| --- | --- | --- |
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
| --- | --- |
| **04 January 2024** | **11 January 2024** |

| Name and mailing address of the ISA/CN | Authorized officer |
| --- | --- |
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/129362**

| Patent document cited in search report | | | Publication date (day/month/year) | Patent family member(s) | | | Publication date (day/month/year) |
|---|---|---|---|---|---|---|---|
| WO | 2021254508 | A1 | 23 December 2021 | EP | 4160956 | A1 | 05 April 2023 |
| | | | | US | 2023119339 | A1 | 20 April 2023 |
| | | | | CN | 113824534 | A | 21 December 2021 |
| CN | 109698732 | A | 30 April 2019 | JP | 2021500808 | A | 07 January 2021 |
| | | | | EP | 3691194 | A1 | 05 August 2020 |
| | | | | WO | 2019080813 | A1 | 02 May 2019 |
| | | | | ES | 2908604 | T3 | 03 May 2022 |
| | | | | US | 2020252488 | A1 | 06 August 2020 |
| CN | 112104471 | A | 18 December 2020 | WO | 2020253791 | A1 | 24 December 2020 |
| WO | 2021238791 | A1 | 02 December 2021 | CN | 113726475 | A | 30 November 2021 |
| WO | 2022022727 | A1 | 03 February 2022 | US | 2023171024 | A1 | 01 June 2023 |
| | | | | EP | 4181441 | A1 | 17 May 2023 |
| | | | | CN | 114070475 | A | 18 February 2022 |
| WO | 2022056884 | A1 | 24 March 2022 | JP | 2023541710 | A | 03 October 2023 |
| | | | | BR | 112023005028 | A2 | 18 April 2023 |
| | | | | US | 2023396360 | A1 | 07 December 2023 |
| | | | | KR | 20230069206 | A | 18 May 2023 |
| | | | | EP | 4203354 | A1 | 28 June 2023 |
| | | | | CA | 3195727 | A1 | 24 March 2022 |
| | | | | CN | 113454935 | A | 28 September 2021 |
| | | | | IN | 202337019429 | A | 31 March 2023 |

Form PCT/ISA/210 (patent family annex) (July 2022)

**EP 4 633 071 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310127882